(19) Europäisches Patentamt / European Patent Office / Office européen des brevets

(11) **EP 2 315 508 B1**

(12) **EUROPEAN PATENT SPECIFICATION**

(45) Date of publication and mention
of the grant of the patent:
**12.11.2014 Bulletin 2014/46**

(51) Int Cl.:
**H05K 1/02** *(2006.01)*     **B23K 26/40** *(2014.01)*
**H01L 23/373** *(2006.01)*     **H01L 21/48** *(2006.01)*
**H05K 3/00** *(2006.01)*     **H05K 1/03** *(2006.01)*

(21) Application number: **09766743.0**

(22) Date of filing: **22.06.2009**

(86) International application number:
**PCT/JP2009/061342**

(87) International publication number:
**WO 2009/154295 (23.12.2009 Gazette 2009/52)**

(54) **COLLECTIVE CERAMIC SUBSTRATE, MANUFACTURING METHOD FOR THE SUBSTRATE, CERAMIC SUBSTRATE, AND CERAMIC CIRCUIT SUBSTRATE**

SAMMELKERAMIKSUBSTRAT, VERFAHREN ZUR HERSTELLUNG DES SUBSTRATS, KERAMIKSUBSTRAT UND KERAMIKSUBSTRAT FÜR EINE SCHALTUNG

SUBSTRAT CÉRAMIQUE COLLECTIF, PROCÉDÉ DE FABRICATION DU SUBSTRAT, SUBSTRAT CÉRAMIQUE ET SUBSTRAT DE CIRCUIT CÉRAMIQUE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **20.06.2008  JP 2008161792**
**25.02.2009  JP 2009042071**

(43) Date of publication of application:
**27.04.2011 Bulletin 2011/17**

(73) Proprietor: **Hitachi Metals, Ltd.**
**Minato-ku**
**Tokyo 105-8614 (JP)**

(72) Inventors:
• **TESHIMA, Hiroyuki**
**Kitakyushu-shi**
**Fukuoka 808-0047 (JP)**
• **WATANABE, Junichi**
**Kumagaya-shi**
**Saitama 360-0846 (JP)**
• **KAZUI, Shinichi**
**Hatano-shi**
**Kanagawa 259-1322 (JP)**
• **SASAKI, Makoto**
**Kumagaya-shi**
**Saitama 360-0847 (JP)**
• **MIZUNO, Akihito**
**Kumagaya-shi**
**Saitama 360-0846 (JP)**

(74) Representative: **Möbus, Steffen**
**Kayser & Möbus**
**Patentanwälte**
**Muenchstrasse 3**
**86482 Aystetten (DE)**

(56) References cited:
WO-A1-2008/062496     JP-A- 5 110 213
JP-A- 10 264 130     JP-A- 2000 286 511
JP-A- 2003 031 731     JP-A- 2004 160 478
JP-A- 2008 041 945     US-A1- 2009 220 721

EP 2 315 508 B1

**Description**

Technical Field

The present invention relates to a ceramic assembled board prepared from a sintered ceramic board suitable so as to suitably produce a large number of circuit substrates and a method of manufacturing the same. The present invention also relates to a ceramic substrate obtained by dividing such an assembled board and a ceramic circuit substrate formed by using such a ceramic substrate.

Background Art

A ceramic substrate is employed for a circuit substrate to be utilized for a semiconductor module or a power module from the viewpoint of thermal conductivity, electric insulation and mechanical strength. A circuit substrate is formed by bonding a metal circuit plate of Cu or Al and a metal heat sink to a ceramic substrate. While alumina and aluminum nitride have broadly been employed for ceramic substrates, silicon nitride is becoming very popular these days because this material shows a high mechanical strength and an improved thermal conductivity and hence is durable in a severe environment.

There are known techniques of producing ceramic circuit substrates on a mass production basis by bonding a metal plate such as a copper plate to one or both of the surfaces of a ceramic assembled board for producing a large number of ceramic substrates by an active metal brazing method or a direct bonding method, forming metal circuit plates and metal heat sinks by etching and dividing the ceramic assembled board into individual ceramic circuit substrates of a predetermined size. Scribe lines (grooves) may be patterned on such a ceramic assembled board by means of a laser so as to divide the ceramic assembled board into individual ceramic circuit substrates by applying bending force along the scribe lines.

PTL 1 discloses a silicon nitride substrate produced by forming scribe holes on a sintered silicon nitride board and breaking it and a method of manufacturing such a substrate. The silicon nitride substrate is obtained by forming a plurality of scribe holes at least on a lateral surface thereof typically by means of a laser and conducting a breaking operation along the line connecting the holes, the silicon nitride board being characterized in that the largest height of the rugged part is not greater than 0.1 mm when the rugged part of the lateral surface is viewed from the surface to which a laser beam is irradiated. This arrangement facilitates the breaking operation, and it makes the ends of the substrate hardly liable to produce fissures and cracks at the time of and after the breaking operation.

PTL 2 discloses a technique of irradiating the surface of a ceramic base member with a laser beam to form groove-shaped scribe lines and dividing the ceramic base member along the scribe lines to produce ceramic plates. The disclosed technique is characterized in that a YAG high harmonic laser is employed to irradiate a laser beam of a wavelength not less than 250 nm and not more than 600 nm and the surface layer of the ceramic plate to be irradiated with such a laser beam is of a glass material and has a thickness of not thicker than 10 $\mu$m. This arrangement makes it possible to reduce the thickness of the layer to be heat-affected of the surface layer section to be processed by a laser beam and also reduce micro cracks that can be produced there and also prevent the ceramic substrate from producing fissures during thermal cycle operations.

Finally, PTL 3 discloses a technique of forming groove-shaped split lines by irradiating a laser beam onto the surface of a ceramic board and producing a large number of recesses that are arranged in an overlapping manner. The disclosed technique is characterized in that the split lines are formed by recesses arranged at a processing pitch substantially equal to the processing size of the split lines and it is sufficient for the thickness of the recesses to be about 1/10 to 1/6 of the thickness of the board. This arrangement makes it possible to divide the ceramic board along the split lines with ease and reduce the processing time for laser scribing.

Prior Art Literatures

Patent Literatures

PTL 1: Jpn. Pat. Appln. Publication No. 2007-81024 (Paragraphs 0005 - 0007)
PTL 2: Jpn. Pat. Appln. Publication No. 2008-41945 (Paragraph 0005)
PTL 3: Jpn. Pat. Appln. Publication No. 2000-44344 (Paragraphs 0008 to 0026)

Document JP 2003 031731 A (cf. the preamble of claim 1) describes a ceramic substrate which is obtained by dividing a ceramic sintered body along breaking grooves by way of laser machining to produce a large number of circuit substrates.

Document US 2009/220721 A1 describes a ceramic member with high strength grooves and a method of manufacturing the same. A heat ray is used in combination with a blown gas to form grooves in the surface of the ceramic member.

Disclosure of the Invention

Problems to be Solved by the Invention

Normally, a sintered ceramic board is subjected to a scribing process and a metal plate is bonded to the board. Then, a desired circuit pattern is formed on the metal plate, which is, plated and subsequently divided to produce ceramic circuit substrates. However, the sintered ceramic board can be inadvertently broken in the metal plate boding process before the dividing operation to give rise to a yield problem. Thus, there is a demand for scribing techniques by means of which a ceramic board can be divided with ease in the dividing operation but hardly divided when it is not intended to divide the ceramic board. Additionally, the substrates produced by the dividing operation are desired to show a high degree of dimensional precision and strength. While PTLs 1 and 2 disclose techniques of preventing ceramic substrates from producing fissures and cracks at the lateral surfaces thereof produced by scribing and dividing but are accompanied by a problem that a YAG laser beam is disadvantageous relative to a $CO_2$ laser beam in terms of processing efficiency because the heat generated by the YAG laser beam is poorly absorbed by ceramic although the YAG laser beam has a wavelength shorter than a $CO_2$ laser beam and hence is suitable for precision processing. Particularly, PTL 2 describes the use of a laser beam of a wavelength shorter than 1,064 nm that is normally employed and hence it should take a considerable time for such a laser beam to form groove-shaped scribe lines although the literature does not specifically describe the profile of the grooves to be formed. PTL 3 describes that the processing time is reduced by forming scribe lines by means of a large number of recesses that are formed in an overlapping manner although the literature does not specifically describe about what laser is to be employed and the profile of the grooves to be formed. Thus, it seems to be difficult for the techniques disclosed in these PTLs to produce grooves efficiently at high speed in an industrially feasible manner, although man cannot say decisively from what is known from the literatures. Therefore, it is a general practice to form scribe lines by way of holes arranged discontinuously at certain intervals particularly in the case of very hard sintered ceramic boards.

Meanwhile, a large member of ceramic circuit substrates are produced by arranging a metal circuit plate of Cu or Al and a metal heat sink of also Cu or Al respectively on one of the opposite surfaces and on the other surface of a ceramic assembled board as described earlier. The metal circuit plate and the metal heat sink are bonded by brazing to the entire surfaces of each of the substrate regions defined by scribe lines. However, relatively deep holes are formed discontinuously in a scribing process by irradiating a YAG laser beam or a $CO_2$ laser beam to give rise to a broad heat-affected zone and molten and decomposed scattering objects formed by some of the oxide ingredients containing Si and free silicate acid (such as $SiO_2$) and the ingredients of the sintering aid produced from the oxidized surface of the board or by thermal energy of the laser particularly in the case of a silicon nitride board are scattered around and more often than not adhere to around the holes. Micro-cracks are likely to be produced and a brazing material hardly adheres to adhesion areas on such an oxidized surface of a board to by turn reduce the reliability of bonding and produce voids which lead to defect of the bonding. On the other hand, the brazing material can fall into the discontinuously arranged holes and it is difficult to satisfactorily remove the fallen brazing material from the deep and rough holes. Additionally and generally, a predetermined photoresist pattern is formed on the metal circuit plates and predetermined parts of the metal plates and the brazing material are removed by etching to produce a circuit pattern, which is then subjected to an Ni-P plating process. For this process, the board is immersed in a palladium catalyst solution in order to activate the surface to be plated and subsequently the palladium is removed. However, the palladium that adheres to the brazing material is prevented from depositing in an acidic solution and liable to be left on the brazing material. Then, as a result, the brazing material and palladium can remain on the cut surfaces to cause dielectric breakdowns, which by turn make it impossible to secure the necessary creepage distance between the front surface and the rear surface of the board to give rise to a degradation of dielectric strength.

In view of the above identified problems of the prior art, it is therefore an object of the present invention to provide a ceramic assembled board having scribe lines formed thereon that shows an advantageous dividability of allowing the board to be divided when intended and not allowing it to be divided with ease when unintended and can produce high quality ceramic circuit substrates as well as a method of manufacturing such a substrate. Another object of the present invention is to provide a ceramic substrate produced from a ceramic assembled board by division and showing an excellent degree of dimensional precision and bending strength as well as a ceramic circuit substrate showing a high dielectric strength.

Means for Solving the Problems

In an aspect of the present invention, there is provided a ceramic assembled board according to claim 1. By way of laser machining a large number of circuit substrates, is produced. At least one of the continuous grooves is so formed as to show the smallest groove depth at an end section thereof. The end section may be a non-product region at a corner of the assembled board.

The groove depth may be the numerical value of the largest depth or the smallest depth observed at any point when the depth of at least one of the grooves is longitudinally continuously measured.

For the purpose of the present invention, continuous grooves are characterized in that, when the groove depth is dm and the board thickness is B in a cross section taken at the largest depth part of the grooves, the largest depth dm of the grooves is not greater than B/2, the groove width c is not greater than 0.2 mm and the width c1 of the heat-affected zones formed at the opposite sides of the grooves is not greater than 1.5 times of the groove width c. When the ceramic board is made of silicon nitride and the content of the sintering aid is 3 wt%MgO - 2 wt%Y2O3 as shown in Examples described hereinafter, the width c1 of the heat-affected zones may be such that the surface oxygen concentration thereof is in a range not smaller than 5 wet%. Then, the oxygen concentration will be not smaller than 3.1 times of that of the concentration of the sintering aid.

In the case of an oxide ceramic board, or an alumina board especially, the oxygen concentration thereof is about 47 wt% and, since the initial oxygen concentration is relatively high, the fluctuations of the oxygen concentration at the heat-affected zones are not large after the laser machining and may be in a range not smaller than 56.3 wt%, or about 1.2 times of the above concentration.

Preferably, the displacement of the center line of the groove width c and the deepest part is not greater than c/4 at any arbitrarily taken cross section of the continuous grooves. When the radius of curvature of the bottom section is p at any arbitrarily taken cross section of the continuous grooves, preferably p is such that $\rho/B \leq 0.3$ within the range of $0.1 \leq dm/B \leq 0.5$. The ceramic may be silicon nitride and the continuous grooves may be formed by irradiating a laser beam from a fiber laser.

For the purpose of the present invention, continuous grooves must be formed. only on one of the opposite surfaces.

Dividing grooves are formed by scanning a fiber laser beam by means of a galvano-mirror or a polygon mirror onto the surface of a sintered ceramic board, by using both a mirror scanning operation and an operation of moving the table for securing the board or by using only an operation of moving the table.

At least one of the lateral, surfaces of the ceramic board is a surface formed by dividing the ceramic assembled board along the continuous grooves and the arithmetic mean roughness Ra2 of the machined surfaces of the continuous grooves is smaller than the arithmetic means roughness Ra1 of the surfaces of broken sections with regard to the arithmetic mean roughness Ra of the lateral surfaces. The difference between the Ra1 and the Ra2 is preferably not greater than 10 $\mu$m and more preferably not greater than 5 $\mu$m.

Of the lateral surfaces formed by division along the continuous grooves, the difference between the largest value and the smallest values of the undulations of the break line connecting the bottom sections of the continuous grooves is preferably not greater than 20 $\mu$m and more preferably not less than 15 $\mu$m. The ceramic may be silicon nitride and the continuous grooves may be formed by irradiating a laser beam from a fiber laser.

There is provided a ceramic circuit substrate including a ceramic board according to one of the above definitions, a metal circuit plate arranged on one of the surfaces of the ceramic board and a metal heat sink arranged on the other surface, whereby the metal circuit plate is arranged at the side of the continuous grooves and the metal heat sink is arranged at the side of the break lines.

Since the continuous dividing grooves of a ceramic assembled board according to the present invention are formed by laser machining, cracks can develop from some of the groove sections, which can easily lead to breaking, so that the ceramic board preferably shows a high fracture toughness value $K_{1c}$. The fracture toughness value of the ceramic to be used and the stability of the circuit formation process are closely related. The circuit formation process of a ceramic circuit substrate includes a step where the assembled board is subjected to high pressure, which is a step where etching resist is forced to firmly adhere to the surfaces of the Cu plates of the bonded assembly prepared by brazing the Cu plates to the front surface and the rear surface of the assembled board. Film resist or liquid resist is employed for the etching resist. When the former is used, it is forced to firmly adhere to the surfaces of the Cu plates of the bonded assembly by forcing film resist and the bonded assembly to move through the gap between a pair of thermo-compression bonding rollers by using a compression bonding laminator. When the latter, or liquid resist is used, it is transferred onto the surfaces of the Cu plates of the bonded assembly by using a screen mask plate where a predetermined wiring circuit pattern is formed, applying liquid resist to the printed surface thereof, arranging the bonded assembly at the rear surface side and driving a printing squeeze to move on the surface of the screen mask plate under the load of certain pressure. In either one of the above processes, cracks develop at the starting points of the grooves formed by laser machining at the time of applying the load of pressure when the fracture toughness of the assembled board is less than 3.5 MPa.m$^{1/2}$ and the board is divided irregularly in the course of the etching step for forming a Cu circuit pattern.

When such cracks are produced excessively, there can arise a problem that the substrates drops into the liquid tank through the gap of the conveyor rollers of the etching apparatus. If cracks are not particularly large, the assembled board may not be able to maintain its profile to give rise to a problem that the chemical polishing process and/or the plating process in subsequent steps cannot be properly executed to remarkably degrade the quality stability and the productivity. While the generation of cracks can be suppressed by reducing the load of pressure, then the adhesion strength between each of the resist layers and the corresponding Cu plate falls and the etching solution can permeate into poor adhesion areas to make it difficult to form a desired pattern. In view of these problems, the fracture toughness of an assembled board according to the present invention is preferably not less than 3.5 MPa. $m^{1/2}$ and more preferably not less than 5.0 MPa. $m^{1/2}$ from the viewpoint of mass production and securing the quality stability. For this purpose, the main component of the ceramic to be used for a ceramic assembled board according to the present invention is preferably silicon nitride.

When evaluating the fracture toughness value $K_{1c}$ of a ceramic board, the evaluation was done by sequentially using SiC polishing papers of #300, #600, #1, 000 and #2, 000 and the board material that was mirror-polished by means of 0.5 μm diamond polishing paste and buffing/polishing cloth was measured by way of a IF (indentation fracture) process conforming to JIS-R1607. For the measurement, a diamond indenter was used with a load of 2 kgf and a dwell time of 30 sec.

Advantageous Effects of the Invention

Thus, the present invention provides a ceramic assembled board showing a dividablility of allowing the board to be divided when intended and not allowing the board to be divided with ease when unintended by a fast and high precision manufacturing method.

The present invention also provides a ceramic substrate showing an excellent degree of dimensional precision and bending strength and a ceramic circuit substrate showing a high dielectric strength.

Brief Description of the Drawings

FIG. 1 is a schematic plan view of an embodiment of ceramic assembled board according to the present invention.
FIG. 2 is a schematic lateral view of a ceramic circuit substrate according to the present invention.
FIG. 3 is a schematic transversal cross sectional view of a scribe groove formed according to the present invention.
FIG. 4 is a schematic illustration of a method of forming a scribe groove in a ceramic assembled board according to the present invention.
FIG. 5 is a schematic illustration of the results of measurement of the depth of a scribe groove of a ceramic assembled board according to the present invention.
FIG. 6 is schematic illustration of the profiles and the depths of scribe grooves of a ceramic assembled board according to the present invention.
FIG. 7 is a schematic illustration of the profile of the dividing surface of a scribe groove of a ceramic substrate according to the present invention.
FIG. 8 is a schematic illustration of the position of measurement of the depth of the scribe groove in Evaluation Text 1.
FIG. 9 is a schematic illustration of the width of the heat-affected zone of a scribe groove of a ceramic assembled board according to the present invention.
FIG. 10 is a schematic illustration of an example of breaking probability of a substrate machined by a fiber laser that is applicable to the present invention.

Best Mode for Carrying out the Invention

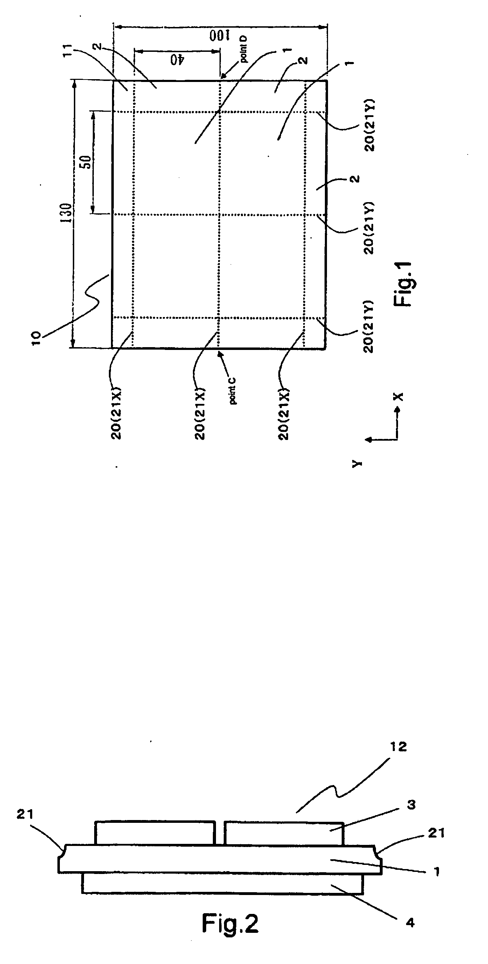

FIG. 1 is a schematic plan view of an embodiment of ceramic assembled board (to be sometimes referred to simply as assembled board hereinafter), or ceramic assembled board 10, according to the present invention. The assembled board 10 is prepared by forming lattice-shaped scribe lines 20 on a sintered silicon nitride board (to be sometimes referred to simply as sintered board) 11 having dimensions of 130 mm × 100 mm × 0.32 mm and four 50 mm × 40 mm ceramic substrates 1 can be produced from the sintered board 11 by division. The scribe lines 20 are drawn as three continuous grooves (scribe grooves) 21 are formed in the X-direction and also three continuous grooves (scribe grooves) 21 are formed in the Y-direction (21x, 21y). The four central areas having four sides defined by the scribe grooves 21 are so many ceramic substrates 1 according to the present invention. The outer peripheral part surrounding the ceramic substrates 1 is a non-product region 2 that will be utilized when handling the assembled board 10 and separated and eliminated when the assembled board 10 is divided to take out the ceramic substrates 1. As will be described hereinafter, the assembled board 10 is provided with scribe grooves 21 having a characteristic depth and a characteristic surface profile and a method of manufacturing a assembled board 10 according to the present invention is characterized by the method of forming such scribe grooves 21. The material of the assembled board 10 may alternatively be aluminum nitride, alumina or the like. The dimensions of a assembled board 10 according to the present invention are not particularly limited to the above-described ones. The number of ceramic substrates 1 that can be produced from a assembled board 10 of the above-described dimensions (130 mm × 100 mm) is between two and tens, although it may vary depending on the dimensions of the ceramic substrate 1 (product substrate). While a sintered board having the above-described dimensions may be used directly as a assembled board 10, a assembled board 10 having the above-described dimensions (130 mm × 100 mm) may be cut out from a sintered board 11 (having dimensions greater than 130 mm × 100 mm) by laser machining to remove four edge parts of the sintered board 11 when the dimensional precision of the machining is limited in the manufacturing process. While scribe grooves are generally formed to show a lattice-shaped pattern so as to produce rectangular substrates, they many not necessarily be formed in such a way. For example, they may be formed so as to produce triangular or polygonal substrates or curved scribe grooves to produce substrates of a desired shape.

A ceramic circuit substrate 12 according to the present invention has a metal circuit plate 3 arranged on one of the surfaces of a ceramic substrate 1 produced by dividing a assembled board 10 as described above and a metal heat sink 4 arranged on the other surface like any prior art ceramic circuit substrate as shown in FIG. 2. Scribe grooves 21 are formed on the sintered board 11 and subsequently the board surfaces are subjected to a liquid honing process before the metal plates 3 and 4 that the ceramic circuit substrate 12 has are bonded by brazing or the like and undergo predetermined processing steps such as etching for forming a circuit pattern, although the scribe grooves 21 may alternatively be formed after bonding or processing the metal plates 3 and 4. In a ceramic circuit substrate 12 according to the present invention, a metal circuit plate 3 is bonded to the surface where scribe grooves 21 are formed (the groove side), whereas the metal heat sink 4 is bonded to the opposite surface (the broken side). In general circuit substrates, a semiconductor device is mounted by solder onto the metal circuit plate 3 where a circuit pattern is formed as shown in FIG. 2. Particularly, power semiconductor devices (diodes, MOS-FETs, IGBTs, thyristors, etc.) emit heat to a large extent in operation so that circuit substrates 12 having a metal circuit plate 3 of a thickness equal to or greater than that of a metal heat sink 4 are popularly employed. With such an arrangement, the ceramic substrate 1 or the assembled board 10 may sometime be warped and deformed to protrude at the side of the metal heat sink 4. When such a warped profile appears and scribe lines 20 are formed at the side of the metal heat sink 4, the substrate can be torn apart along the scribe lines 20 at an unexpected stage due to the warp. In this respect, a ceramic circuit substrate 12 according to the present invention can effectively prevent such a breakage from taking place in the manufacturing process.

The scribe lines 20 of a assembled board 10 according to the present invention are formed by scribe grooves 21. Conventionally, $CO_2$ lasers are mainly employed for effectively laser-scribing sintered boards that are made of alumina or aluminum nitride because they show an excellent absorption characteristic. On the other hand, however, $CO_2$ lasers cannot give rise to a small focus diameter nor can it provide a large depth of focus so that consequently they are accompanied by a problem of producing a large heat-affected zone because a large area is irradiated by a laser beam and the substrate is degraded to show a reduced strength by the laser beam irradiation and a problem of generating a large number of micro-cracks that are attributable to distortions by heat. To minimize these problems, scribe lines are formed by way of a large number of discontinuously arranged holes. However, it is not possible to produce scribe holes of a small diameter that are excellent in terms of profile and degree of precision so that consequently the produced substrate has a problem of inaccurate dimensions and roughness of the divided surfaces. Furthermore, since sintered boards of silicon nitride that is a major material to be used for the purpose of the present invention have a higher strength and a higher toughness than those of alumina or aluminum nitride, they are desired to have continuous grooves rather than discontinuously arranged holes so as to be reliably dividable.

A method of manufacturing a ceramic assembled board according to the present invention includes a step of forming continuous grooves for dividing preferably by scanning a fiber laser beam onto a sintered ceramic substrate by means of a galvano-mirror or a polygon mirror, by scanning a fiber laser beam and at the same time moving the table for securing the substrate or only by moving the table. A fiber laser is a laser adapted to use a waveguide as laser oscillator and a fiber-like laser medium formed by elongating and narrowing the laser medium of a YAG laser (YAG crystal) that is most popular as industrial laser. The capacity of cooling a solid-state laser is expressed by the surface area (S) divided by the volume (V) of the laser medium, or S/V, so that the capacity of cooling a solid-state laser can be raised by reducing r (radius) or L (length/thickness) of the laser medium. A fiber laser that can provide a large heat emitting area in the longitudinal direction thereof can be cooled with a small cooling system if it has a high output power and is free from the thermal lens effect problem (the problem that the beam quality is degraded by the temperature gradient produced in the inside of the crystal) that accompanies known high output power lasers. The fiber core of a fiber laser through which light propagates actually has a very small diameter of several microns so that light propagates in a single mode that is necessary for stable laser oscillation without giving rise to higher modes oscillations if the laser is energized by large power to achieve a high output power level. The high level light amplification effect in the very narrow waveguide of several microns results in a completely saturated amplification to get high output efficiency of the energy accumulated in the laser medium so that the laser can oscillate highly efficiently to emit a high quality and high luminance laser beam at a high output power level. The focusing performance of a fiber laser is influenced by the fiber diameter and fiber laser has a very small fiber diameter and can operate for light transmission in a single mode. A fiber laser shows a beam intensity close to that of a carbon dioxide gas laser in a laser machining operation and the wavelength of the laser beam of the former is shorter by a digit than the wavelength of the laser beam of the latter. Thus, it emits a laser beam that can make a work to be machined show a high beam absorptivity and is effective for welding and cutting operations due to the beam energy absorption reducing effect it has relative to plasma. A double-clad fiber including a core and an outer layer section is employed for fiber laser oscillators and the core fiber is a laser medium doped with a rare earth element such as Yb or Er. LD (laser diode) excitation light introduced into the internal clad layer energizes the core fiber as the light is transmitted through the inside of the fiber and is reflected by the diffraction gratings buried at the opposite ends of the fiber due to the principle of FBG (fiber bragg grating) so that the light is amplified as the light is forced to reciprocate by reflections. The core fiber diameter is about 10 $\mu$m and the emitted beam is transmitted subsequently in a single mode. As for laser oscillation of a fiber laser, Er ions, for instance, can amplify light of 1, 550 nm as light of 980 nm is entered as excitation light. A semiconductor laser is employed as excitation light source and light of 1,550 nm is made to resonate between a pair mirrors by way of a WDM (wavelength division multiplexing) coupler and an output laser beam is obtained by means of a PBS (polarization beam splitter). A fiber laser is a simple and effective device that can stably operate for laser oscillations and generate high frequency ultra-short pulses.

The advantages of a fiber laser can be summarized as follows. (1) It can be downsized dramatically.

While conventional bulk type lasers require a linear space through which light passes. To the contrary, a fiber laser can dramatically reduce the space required for laser oscillation while maintaining the light path length when an optical fiber is wound for use. (2) It shows an output stability.

For laser oscillation, a standing wave needs to be produced in the resonator and the mirror positions need to match the node positions of the standing wave. Therefore, the positional displacements of optical parts due to temperature changes and vibrations give rise to problems in the case of a bulk type laser. Sophisticated techniques and knowledge on lasers are required for adjusting the optical system of a bulk type laser. In the case of a fiber laser, to the contrary, the problem of positional displacements can be dissolved by way of the use of connection techniques such as fiber couplers and fusion bonding and laser oscillations can stably be realized. (3) It shows an instant responsiveness and excellent high frequency characteristics.

It is highly responsive to output control operations. No idling operation is required for a fiber laser, which can be driven to output a laser beam immediately once started. Therefore, for pulse modulation outputs, it can be operated at any desired high pulse wavelength between 0 and 100%. (4) It can be driven at a high output power level.

Its output power range can be extended to a kW level by installing an additional power module for controlling the laser oscillation.

Other advantages include (5) it is substantially maintenance-free, (6) it involves few consumables, (7) it requires low running cost and (8) it requires only a small initial investment.

As for workability, its advantages include (1) it can be used for bonding and cutting with high accuracy of a wide range of plate materials extending from thin plates to thick plates, (2) it can operate at high speed, (3) it can be operated on a work with only small distortions and reduce the residual stress at bonded surfaces and (4) it can be remotely operated. Because fiber lasers provide the above listed advantages if compared with conventional YAG lasers and $CO_2$ gas lasers, the fiber lasers are expected to operate as excellent and valuable industrial machining tools.

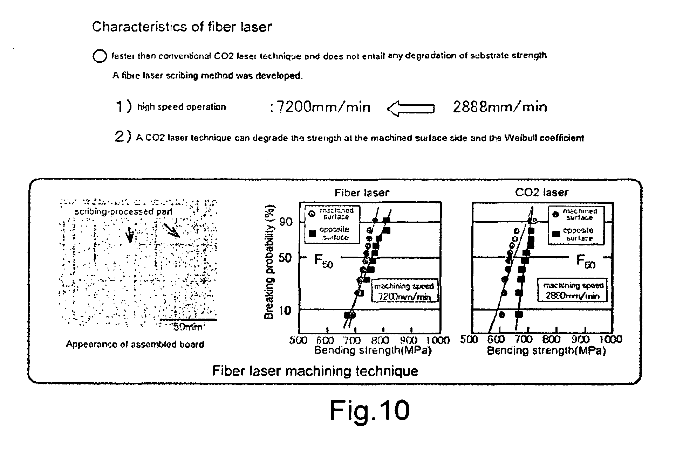

FIG. 10 is a schematic illustration of an example of breaking probability at the front and rear surfaces of a ceramic board that is subjected to a scribing process by a fiber laser that is applicable to the present invention. FIG. 10 shows that the substrate strength is degraded by the use of a fiber laser only to a small extent if compared with a conventional process using a $CO_2$ laser.

An assembled board 10 according to the present invention is intended to be manufactured to show an excellent cost performance so that scribe grooves 21 need to be produced effectively. Thus, for the purpose of the present invention, scribe grooves 21 are formed using a fiber laser. A fiber laser is characterized in that the laser beam it emits can be focused excellently to a very small spot with a large depth of focus and that it shows a high conversion efficiency and can operate at a high output power level. Thus, it can highly precisely form a substantially continuous groove showing a substantially constant cross section at high speed by irradiating a laser beam at a high repetition frequency of tens of several KHz to several MHz to produce a high energy density. Then, as a result, it is possible to control the groove depth and a narrow scribe groove 21 can be formed with little surface roughness at the laser-irradiated surface. Additionally, the scope of the heat-affected layer c1 near the scribe groove 21 where the substrate is degraded by the laser beam irradiation can be reduced and the scribe groove 21 can be produced with suppressed generation of micro-cracks that are attributable to accumulated heat. While it is assumed for the purpose of the present invention that a fiber laser is currently an optimum means, the present invention is by no means limited to the use of a fiber laser so long as an assembled board of a comparable quality and similar characteristics can be obtained.

An assembled board 10 according to the present invention shows such a dividability that the assembled board 10 can be divided in an excellent way when intended but is hardly broken when unintended such as when the assembled board 10 is being conveyed by a conveyer or otherwise handled, when a metal plate is bonded to the assembled board 10, when the assembled board 10 is subjected to a warp check process or a warp correcting process or when resist is being applied to it in order to form a circuit pattern thereon. Additionally, the assembled board 10 has excellent quality-related characteristics including that the ceramic substrates 1 produced by dividing it are excellent in terms of dimensional precision, physical strength and dielectric strength. In other words, a scribe groove 21 according to the present invention has parts whose depths differ when viewed from the dividable surface and shows a small groove width and low groove roughness. While the above identified quality problem relates to a ceramic circuit substrate 12 including a ceramic substrate 1, it phenomenally arises at the ceramic substrate 1 so that it will be described below as the problem on a ceramic substrate 1. The profile of and the method of forming a scribe groove 21 will be described below. The profile is defined on the basis of the evaluation test, which will be described in detail hereinafter.

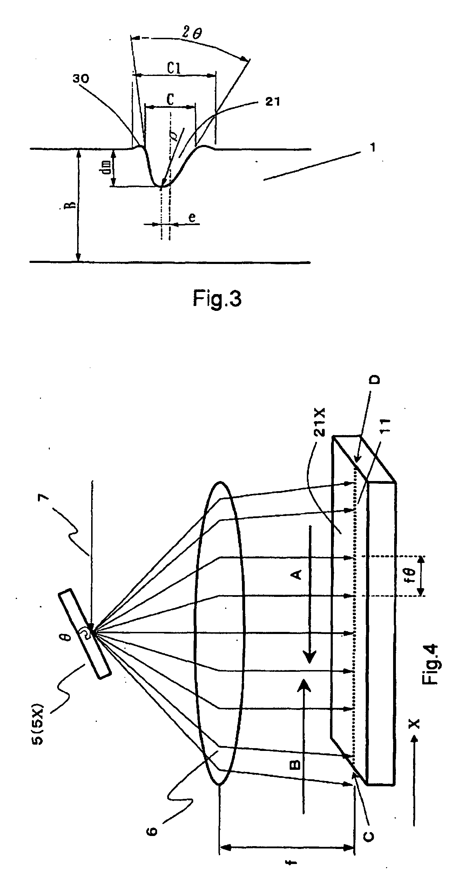

Firstly, dividability will be described below with reference to FIGS. 3 to 6.

When observed immediately after the laser machining operation for producing the scribe groove 21, it shows a reference depth dm that allows the assembled board 10 to be divided satisfactorily for most of its entire length but has parts whose depth is slightly smaller than reference depth dm. More specifically, the scribe groove 21 has a reference groove depth part along which the assembled board 10 can be divided in a dividing operation when a predetermined bending load is applied to it, and shallow groove parts that operate as resisting parts for preventing the assembled board 10 from being inadvertently divided along the scribe groove 21 at any other time. While the shape and the dimensions of the shallow groove sections may be defined by taking the strength and the thickness of the sintered board 11 and the reference depth and the length of the groove to be formed into consideration, the difference $\Delta d$ between the reference groove depth part and the shallowest areas of the shallow groove parts is preferably not less than 10 $\mu$m and not more than 50 $\mu$m from the results of the evaluation test 1, which will be described in detail hereinafter. While an appropriate value may be selected for the reference depth dm by considering the thickness and the material of the sintered board 11, the risk of being inadvertently broken rises when a large value is selected for the reference depth dm. Additionally, when the reference depth is made large, the assembled board 10 can easily be divided along the scribe groove 21 and the groove width necessarily becomes large to reduce the dimensional precision of the ceramic substrates produced by dividing the assembled board along the scribe groove 21 in addition to a long machining time that is required to produce the scribe groove 21. Therefore, the reference depth is preferably not more than 1/2 of the thickness of the sintered board 11.

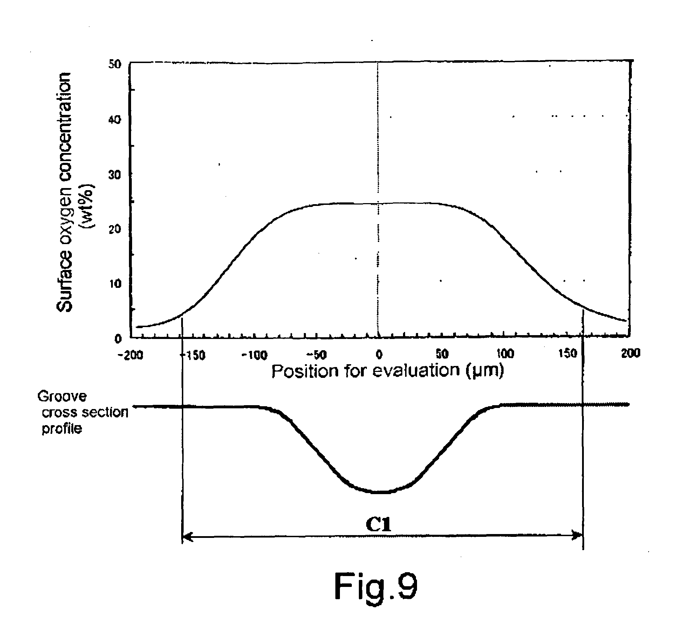

Additionally, as scribe lines are formed as so many continuous grooves with high precision, it is sufficient for an assembled board to be provided with scribe lines only at one of the opposite surfaces. Furthermore, it is possible to reduce the reference depth dm to about 1/10 of the thickness of the assembled board while a small value is selected for the radius of curvature p of the bottom sections of the grooves so as to make the bending stress applied to a groove to be concentrated to the bottom section thereof. More specifically, as may be conceivable by seeing the evaluation test 2, which will be described in detail hereinafter, preferably $\rho/B \leq 0.3$ within the range of $0.1 \leq dm/B \leq 0.5$. The radius of curvature p can be reduced preferably by machining the assembled board so as to produce a narrow scribe groove width c. As the scribe groove width c is reduced, the accuracy of the dimensions of each ceramic substrate produced from the assembled board is improved and the creeping distance is prolonged to improve the dielectric strength. Then, at the same time, the surface area of the metal circuit plate 2 can be increased and the mounting density of electronic components can be raised. It will be understood that the groove width c is preferably not more than 0.2 mm by seeing the data in Table 2 (Sample No. 5), which will also be described in detail hereinafter. The range of laser beam irradiation can be reduced to reduce the width of the grooves to be produced by laser machining if a fiber laser is employed so that the width of the heat-affected zone c1 can also be reduced to suppress fissures and cracks on the dividing surface side. Preferably, the groove cross section is substantially V-shaped with an aperture angle $2\theta_1$ not more than 120°. For the purpose of the present invention, the heat-affected zone c1 defines the degree of oxidation of the surface and hence the surface oxygen concentration. More specifically, as shown in FIG. 9, the surface oxygen concentration is sequentially analyzed in the direction of traversing the cross section of the scribe groove 21 (from the left to the right of the sheet of FIG. 3) and the zone where the surface oxygen concentration is not less than 5 wt% (in other words MgO and $Y_2O_3$ are added respectively by 3wt% and 2wt% as sintering aids (oxides)) is defined as heat-affected zone c1 (the surface oxygen concentration can be not less than 5wt% if not affected by heat when $Si_3N_4$ is added to a relatively large extent as sintering aid). A scribe groove 21 can be observed visually and through a optical microscope as black section. When the surface oxygen concentration exceeds about 20 wt%, the heat-affected section can be observed outside the groove as discolored section through an optical microscope and raised areas 30 can arise along the opposite sides of the groove (although cannot be observed through an optical microscope). However, the heat-affected zone beyond the raised area cannot be clearly confirmed through an optical microscope. For this reason, the heat-affected zone c1 is defined by means of surface oxygen concentration as described above in order to make the heat-affected zone clear if it cannot be confirmed through an optical microscope.

The substrate has a thickness B of preferably between 0.2 mm and 1.0 mm, more preferably between 0.25 mm and 0.65 mm. When the thickness B of the substrate is less than 0.2 mm, the dielectric breakdown voltage (dielectric strength) between the front surface and the rear surface of a circuit substrate prepared by using it tends to be varied, although the dielectric breakdown voltage may maintain 7 kV. When, on the other hand, thickness B is 1.0 mm, a rate-determining process appears to obstruct heat emission to eventually give rise to a problem of a raised thermal resistance at the circuit substrate if the thickness of the ceramic substrate is increased because of the difference of thermal conductivity between the circuit forming metal plate and the ceramic substrate operating for insulation, although the dielectric strength is varied only to a small extent to establish an excellent dielectric strength voltage stability. Further, since it is difficult to increase the cost of law materials used and to perform drying operation at the time of forming a sheet, the drying zone of a doctor blade forming machine requires large area, which results in increase of production cost.

Now, a method of manufacturing an assembled board 10 that is characterized in the technique of forming a scribe groove having shallow groove parts by laser machining will be described below by referring to FIG. 4.

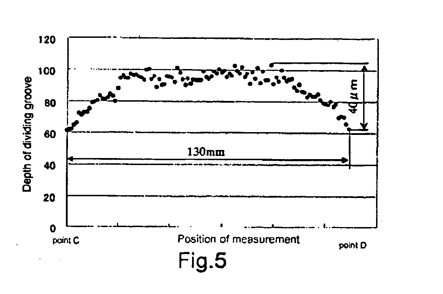

Firstly, for instance, a sintered board 11 containing silicon nitride as main component and having dimensions of 130 mm × 100 mm × 0.32 mm as described above is prepared by using a sintering aid of 3 wt%MgO - 2 wt %$Y_2O_3$. The sintered board 11 is mounted on a worktable and the irradiation section of a fiber laser is arranged above the sintered board 11. A fiber laser includes a fiber core doped with an amplifying medium (e.g., Yb) and arranged in the fiber such that, as excitation light is generated by a laser diode and transmitted through the fiber, it is reflected and amplified by the reflectors at the opposite ends before being output. The fiber laser is compact but stably provides a laser oscillation with a high output power level and short pulses. Particularly, it is advantageous in that it provides a high degree of freedom for adjusting the depth of the groove it cuts and the pulse width of the laser beam it emits because it can output a laser beam having a small beam diameter and a high energy density with a large depth of focus as pointed out above. The irradiation section of the fiber laser has a bi-axial galvano-mirror 5 or polygon mirror of X and Y-axes and a focusing lens 6 that is an fθ lens. The laser beam emitted from the laser oscillator of the fiber laser 7 is then deflected by the galvano-mirror 5 and irradiated onto the sintered board 11 so as to be focused at the surface of the sintered board 11 by the focusing lens 6. An fθ lens is a lens so designed that it provides a constant scanning speed both at the lens peripheral section and at the lens center section. Thus, as shown in FIG. 1, a scribe groove 21x is formed as a continuous groove of a predetermined profile in the transversal (X) direction of the sintered board 11 as X-axis galvano-mirror 5x is driven to turn by angle θ2 to scan a laser beam 7 at a constant speed fθ in the direction of arrow A. When the operation of forming the scribe groove 21x is completed, a Y-axis galvano-mirror (not shown) is driven to turn by a predetermined angle to shift the position of irradiation by a predetermined distance in the longitudinal (Y) direction to form a scribe groove 21y in the Y-direction. X-axis galvano-mirror 5x is driven to turn again to scan a laser beam 7 in the direction of arrow B parallel to the scribe groove 21x, and then a new scribe groove 21x is formed. The above-described sequence of operation is repeated to produce all the X-directional scribe grooves 21x and all the Y-directional scribe grooves 21y as intended and finishes the operation of forming an assembled board 10. Note that the selected specifications of the focusing lens 6 are such that a laser beam 7 is irradiated perpendicularly to the sintered board 11 at the longitudinal center section of each scribe groove 21 but radially at the opposite ends of the scribe groove 21 and the focusing lens 6 is arranged right above the center section of the sintered board 11 and separated from the latter by the focal length thereof. Then, the scribe groove 21 has a substantially same depth within the vertical irradiation range at the center thereof but the depth of the scribe groove 21 is gradually decreased toward the opposite ends because the irradiated light beam becomes out of focus near and at the opposite ends. FIG. 5 is a schematic illustration of the data on the results of measurement of the depth of a scribe groove formed in the above-described way. More specifically, FIG. 5 shows the distribution of depth of a single scribe groove (21x) having a length of 130 mm that is produced by continuous machining. The points C and D in FIGS. 4 and 5 correspond to the opposite ends of the continuous groove.

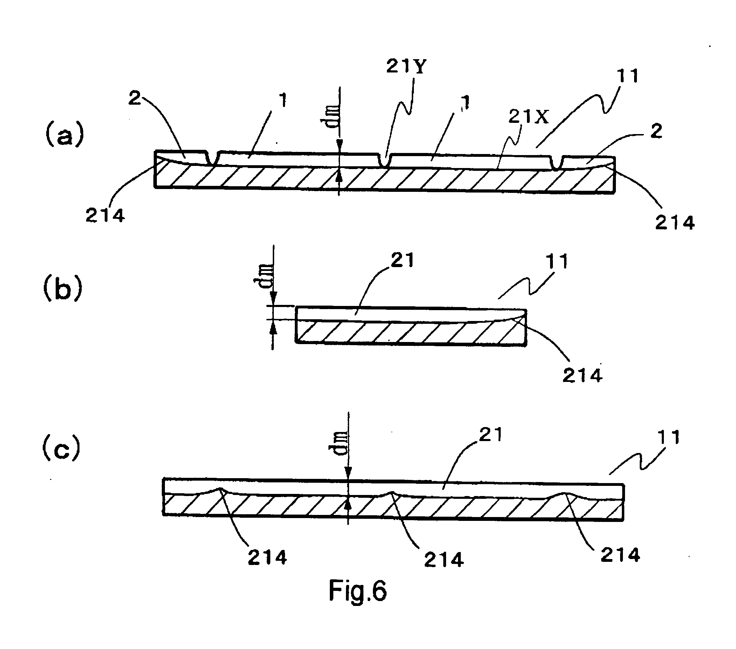

The difference Δd of groove depth between the central section and the opposite ends can be controlled so as to be not more less than 10 μm and not more than 50 μm as described above by sequentially using focusing lenses 6 having different focal lengths or by shifting the height f of arrangement of a focusing lens 6. The actual difference of groove depth may be selected according to the strength and the thickness of the sintered board 11 and the reference depth dm and the length of the scribe grooves 21 to be formed. In the case of the assembled board 10 shown in FIG. 1, the scribe grooves 21 of each ceramic substrate 1 may have a reference depth dm within the four sides thereof but shallow groove sections 21 may be formed in the end margin section that becomes a non-product region 2 as shown in FIG. 6(a). With such an arrangement, the lateral surfaces of the ceramic substrates 1 that are formed by dividing the sintered board are originally divided by the scribe grooves of the uniform depth so that the lateral surfaces of the ceramic substrates 1 show substantially same properties including the surface roughness to make it possible to suppress the possible quality variation among the ceramic substrates 1. Additionally, if cracks and/or burrs are produced at the cut surfaces of the non-product region 2 because the scribe grooves 21 are shallow there and/or even the non-product region 2 is inadvertently cut away from the scribe grooves 21, the risk of producing a resultant damage in any of the ceramic substrates 1 can be minimized. Furthermore, the end parts of the sintered board are likely to be subjected to external force while the substrate is being handled, but they are relatively strong because of the shallow groove sections 214 so that the risk of being inadvertently damaged will be reduced.

Shallow groove sections 214 may not necessarily be formed at opposite end parts of the scribe grooves 21. Alternatively, they may be formed only at an end part of the scribe grooves 21 or at an arbitrarily selected part of each scribe groove 21. In short, there are no limitations to the arrangement of shallow groove sections 214. When, for example, shallow groove sections 214 are formed only at an end part of the scribe grooves 21, they can be produced by shifting the position of arrangement of the focusing lens 6 in the direction of the groove to be formed. For example, if the position of the focusing lens 6 is shifted toward an end part of the scribe grooves 21, the scribe grooves 21 may show a reference depth dm from that end part toward the central part but shallow groove sections may be formed at the opposite end part of the scribe grooves 21 as shown in FIG. 6(b). Such an arrangement may be suitable when the scribe grooves have a short length. The groove depth can be made to vary by varying the output power of the laser. The technique of varying the output power may be used solely or in combination with the technique of scanning the galvano-mirror 5 to form a shallow groove section at any arbitrarily selected position of each scribe groove 21 as shown in FIG. 6(c). However, note that it is not necessary to intentionally reduce the depth of each scribe groove at an arbitrarily selected part thereof for the purpose of the present invention. The only requirement for the depth of a scribe groove is that the difference of groove depth between the deepest part and the shallowest part of the scribe groove is within the range between 10 and 50 $\mu$m for the purpose of the present invention.

While the sintered board 11 is rigidly secured and the laser beam 7 is scanned and moved in the above description, the sintered board 11 may be mounted on a uniaxial or bi-axial table so as to make the sintered board 11 movable and scribe grooves 21 may be formed by a composite operation of moving both the laser beam 7 and the sintered board 11. For example, the operation of moving the laser beam 7 in the longitudinal (Y) direction by means of a Y-axis galvano-mirror may be replaced by an operation of moving the sintered board 11 in the direction of the Y-axis. With such an arrangement, adjustment operations including the alignment operation for forming a scribe groove can be conducted with ease. Alternatively, the laser beam 7 may be made to irradiate a constant point without being deflected by a galvano-mirror 5 and the sintered board 11 may be driven to move in two directions of the X-axis and the Y-axis to form a scribe groove 21. In such an instance, the machining time is defined by the reciprocating speed of mechanically moving the worktable and the moving speed of the table that entails a large force of inertia inevitably needs to be decelerated to switch the moving direction so that the technique of moving the worktable is disadvantages from the viewpoint of high-speed machining, although it provides an advantage that a simple mechanism can be used for the laser optical system. Additionally, when a shallow groove section is to be formed at a midway position of the groove, the output power of the laser has to be changed at a predetermined position, which requires a cumbersome operation from the control point of view. A still alternative technique is to use a lens having a small focal length for the focusing lens 6 as means for forming a shallow groove section 214 at an arbitrarily selected position. For example, machining for 21x and machining for 21y overlap with each other at the crossing of scribe grooves 21 (21x and 21y) of a sintered board 11 to inevitably make the groove depth large there. Then, a shallow groove section 214 may be formed at the crossing of the scribe grooves 21x and 21y to prevent a deep groove depth from being produced there. Besides, a technique of scanning and moving a laser beam by means of a galvano-mirror and a technique of moving a worktable may be employed in combination to form a scribe groove. Alternatively, a groove may be formed at a marked particular position by scanning and moving a laser beam.

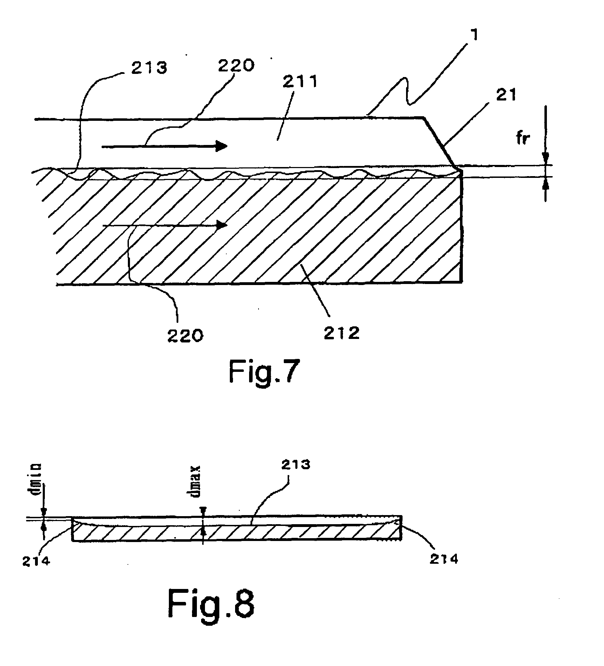

Now, the quality characteristics of a ceramic substrate 1 will be described by referring to FIGS. 2 and 7.

A ceramic substrate 1 formed by dividing an assembled board 10 according to the present invention has at least a divided surface as a lateral surface thereof. The lateral surface is not machined any further and hence the surface profile of the divided surface affects the quality of the ceramic substrate 1 in terms of dimensional precision, bending strength and dielectric strength. The divided surface includes a laser-machined surface 211 of the scribe groove 21 and a broken surface 212 formed when the ceramic substrate 1 is produced by dividing the assembled board 10. A laser scribing operation is conducted by causing a high output power laser pulse to oscillate at a high frequency for the purpose of the present invention. If a laser pulse is made to oscillate at 50 kHz and driven to move at a moving speed of 100 mm/sec for scribing, the laser pulse will move at a pitch of 2 $\mu$m in the moving direction to produce a groove with small and continuous undulations both at the lateral surfaces and at the bottom surface thereof. When bending force is applied to such a scribe groove 21, the assembled board 10 will be broken at the bottom section of the scribe groove 21 but, since the bottom surface of the scribe groove is smooth and shows only small undulations, the break line 213 defining the boundary of the laser-machined part and the broken surface appears as a substantially straight line showing only little undulations fr both vertically and horizontally. Then, as a result, the breaking force does not show any directional propensities to minimize the degradation of the ceramic substrate 1 in terms of dimensional precision, surface roughness and strength. In an experiment, a scribing operation was conducted at a variable moving speed that was made to vary between 80 and 120 mm/sec and the results did not show any variations.

Since the breaking positions of ceramic substrates are free from variation and fluctuations at the time of dividing an assembled board as described above, a ceramic substrate 1 according to the present invention shows an excellent dimensional precision at the divided surfaces, or the lateral surfaces. A ceramic substrate 1 according to the present invention is subjected to bending stress because it is exposed to thermal shocks and a risk of deformation due to a heat cycle after being turned into a circuit substrate 12. Therefore, the ceramic substrate 1 itself preferably has a high bending strength and hence shows a low surface roughness at the divided surfaces thereof and small heat-affected zones (including micro-cracks). This is because a breakdown can originate from a highly undulated part and/or a coarse part (initial defect) of a ceramic material that is brittle to highly probably degrade its strength particularly when it is subjected to a bending test. Additionally, a divided surface includes a laser-machined surface 211 and a broken surface 212 under the bottom line of the former surface and the both surfaces preferably show a low surface roughness but the surface profile of the broken surface is determined by the material (a broken surface of a circuit substrate of silicon nitride tends to be coarser than that of a circuit substrate of alumina or aluminum nitride because silicon nitride particles show a pillar-like profile). A laser-machined surface showing a low surface roughness is advantageous in terms of bending strength. Of the divided surfaces of a ceramic substrate 1 according to the present invention, the laser-machined surfaces are less coarse than the broken surfaces thereof and damaged only little at the time of laser machining and the break lines are smooth as proved by the data shown in Table 3, which will be described in detail hereinafter. Thus, as a result, the lowering ratio of the bending strength of a ceramic substrate 1 is suppressed. For the purpose of the present invention, the lowering ratio of the bending strength is computed by referring to the bending strength of a ceramic substrate, all the lateral surfaces of which are machined to minimize undulations and surface roughness. In the examples that will be described in detail hereinafter, scribe grooves were formed on an assembled board using a fiber laser and the latter substrate was cut along the grooves to obtain test pieces having a length of 40 mm $\times$ a width of 10 mm $\times$ a thickness of 0.32 mmt. Each test piece was subjected to a strength test that was a 4-point bend test, in which the side of the surface where scribe grooves were formed was pulled. On the other hand, a strength test piece that had dimensions of 40 mm $\times$ 10 mm $\times$ 0.32 mmt and operated as reference was prepared separately as a bending test piece by using the same sintered lot of silicon nitride and by means of slicer-machining. All the samples of silicon nitride substrates having different thicknesses were made to show a length and a width same as those of the test piece. The 4-point bend test was conducted under conditions including that a distance between upper-fulcrums of 10 mm, a distance between lower-fulcrums of 30 mm and a crosshead speed of 0.5 mm/min. The surface roughness of the laser-machined surface 211 and that of the broken surface 212 of each divided surface were measured in a non-contact manner by means of a laser microscope because the region of measurement was very small.

Two metal plates 3 and 4, one for a circuit and the other for heat emission, are bonded to the respective opposite surfaces of a ceramic circuit substrate 1 according to the present invention and the ceramic circuit substrate 1 shows an excellent dielectric strength. This is because of the following reason. When a metal plate is bonded to a ceramic substrate that is subjected to laser machining for forming scribe grooves 21, the brazing material applied to the surface of the sintered board can inadvertently get into the scribe grooves 21 but the brazing material, if any, that has got into the scribe grooves of a ceramic substrate according to the present invention can be removed with ease because the laser-machined surfaces thereof shows undulations only to a small extent. Additionally, the surfaces of a ceramic circuit substrate 1 according to the present invention is Ni-plated after the metal plates 3 and 4 are bonded there in a plating process in which the substrate is immersed into and moved away from a palladium catalyst solution and the palladium residue can adhere to the brazing material to produce spots and also to the brazing material that has got into the scribe grooves 21. However, according to the present invention, the brazing material that has got into the scribe grooves can be removed with ease as described above and the palladium adhering to it is also removed with the brazing material so that no palladium will be left behind. Furthermore, some of the Si in the sintered board can be molten and scattered around at the time of laser machining for producing scribe grooves and the scattered Si and/or the oxide thereof ($SiO_2$ and so on) can adhere to the substrate. In such a case, the brazing material will hardly adhere to the areas where Si has already adhered to give rise to defective bonding for the metal plates 3 and 4. However, the molten material is scattered only to a small extent and the heat-affected zones are limited in the case of fiber laser machining for producing scribe grooves so that the defective bonding areas along the scribe grooves of the metal plate are very small. For these reasons, the dielectric strength of a ceramic circuit substrate 1 according to the present invention is prevented from being degraded. While there are methods of cleaning the surface of an assembled board 10 by blasting or a honing process after the laser machining, it is difficult to satisfactorily remove the substances adhering to the walls of the divided scribe grooves 21.

(Evaluation Test 1)

The dividability of scribe grooves 21 having shallow groove sections 214 were evaluated. Table 1 shows some of the data obtained by the test. Sintered substrates (sintered boards) of silicon nitride having dimensions same as those of the one shown in FIG. 1 and a thickness of 0.32 mm were prepared and a laser beam was scanned to each sintered substrate by means of a fiber laser 7 and a galvano-mirror 5 along the X-directional scribe lines (130 mm) out of the scribe lines 20 shown in FIG. 1 and focused to them by means of a focusing lens 6 to produce three scribe grooves 21x. In a subsequent honing processing step, liquid containing polishing particles of alumina or the like was injected onto the front and rear surfaces of the assembled board 10 under pressure to clean and smooth the front and rear surfaces of the assembled board 10 and thereafter the assembled board 10 was dried and divided by hand. The tested sintered boards showed a bending strength of 750 MPa in terms of sintered lot average and a fracture toughness value of 6.5 MPam$^{1/2}$. The fiber laser 7 emitted a laser beam having a wavelength of 1. 06 $\mu$m, which was oscillated at 50 KHz and irradiated repeatedly at a moving speed of 100 mm/sec. Shallow groove sections were formed by arranging a focusing lens 6 at a position above the center of each scribe line 20, at a position above an end of the scribe line 20 or by using focusing lenses 6 having different focal lengths. All the scribe grooves 21 were made to show a groove width c of 0.1 mm. The groove depth of each scribe groove 21 was observed from the corresponding lateral side as the depth of the break line 213 from the substrate surface as shown in FIG. 8. Both the largest groove depth dmax and the smallest groove depth dmin were actually measured. The above testing operation was conducted on three sintered boards and a total of nine scribe grooves were measured for the groove depth. Subsequently, the divided surfaces of each scribe groove 21 were touched by hand to get the feeling thereof and visually observed to evaluate the dividability. The groove depth of each example shown in Table 1 is the average of nine scribed grooves that were formed under the same conditions and the dividability of each example in Table 1 shows a typical evaluation obtained from the nine grooves. Sintered substrates of silicon nitride having a substrate thickness of 0.2 mm and ones having a substrate thickness of 0. 63 mm were also prepared and scribe grooves 21x were formed on them under the same conditions and measured for the depth in a similar manner. Theses substrates were also evaluated for dividability on the basis of the feeling obtained by touching the divided surfaces of each scribe groove by hand and the results of visual observation of the divided surfaces after dividing the substrates by hand. Apart from the above evaluations, a grooved substrate of each type was prepared and dropped onto a concrete floor to see if fissures and cracks were produced at the scribed section or not. This test was conducted from the viewpoint of operability and yield because a substrate having scribe lines can be used for products if it is dropped on the floor due to mishandling but no cracks are produced in the scribe grooves.

[Table 1]

| | substrate thickness D(mm) | groove depth (mm) | | difference of depths (mm) (dmax-dmin)=Δd | dividability |
|---|---|---|---|---|---|
| | | largest groove depth dmax | smallest groove depth dmin | | |
| Example 1 | 0.324 | 0.127 | 0.089 | 0.038 (38 $\mu$m) | ○○ |
| Example 2 | 0.332 | 0.125 | 0.107 | 0.018 (18 $\mu$m) | ○ |
| Example 3 | 0.328 | 0.126 | 0.086 | 0.040 (40 $\mu$m) | ○○ |
| Example 4 | 0.328 | 0.178 | 0.165 | 0.013 (13 $\mu$m) | ○ |
| Example 5 | 0.202 | 0.077 | 0.058 | 0.019 (19 $\mu$m) | ○ |
| Example 6 | 0.205 | 0.086 | 0.041 | 0.045 (45 $\mu$m) | ○ |
| Example 7 | 0.627 | 0.273 | 0.227 | 0.046 (46 $\mu$m) | ○○ |
| Example 8 | 0.639 | 0.22 | 0.202 | 0.018 (18 $\mu$m) | ○○ |
| Comp.Ex. 1 | 0.321 | 0.121 | 0.066 | 0.055 (55 $\mu$m) | Δ |
| Comp. Ex. 2 | 0.317 | 0.032 | 0.026 | 0.006 (6 $\mu$m) | × |
| Comp. Ex. 3 | 0.195 | 0.079 | 0.075 | 0.004 (4 $\mu$m) | ○ |
| Comp. Ex. 4 | 0.623 | 0.192 | 0.127 | 0.065 (65 $\mu$m) | Δ |

Explanation of dividability

○○: The substrate shows little resistance but can be divided without problem. The divided surface is clear.

○: The substrate can be divided by weak force and the divided surface is clear.

Δ: The substrate is divided when bent strongly. The broken surface of the shallow groove section shows small undulations.

×: The substrate cannot be divided unless bent fairly strongly. The broken surface of the groove shows large undulations.

The target thickness of the sample substrates of Examples 1 through 4 and Comparative Examples 1 and 2 was 0.32 mm. As a result of dividing the sample substrates of Examples 1 through 4 by hand, they were divided without problem. On the other hand, both the sample substrates of Comparative Examples 1 and 2 could not be divided until bent strongly because $\Delta$d was not less than 50 $\mu$m for Comparative Example 1 and not more than 10 $\mu$m for Comparative Example 2. Particularly, the sample substrate of Comparative Example 1 showed large undulations and even hollowed areas at the broken surfaces of the shallow groove sections. The sample substrate of Comparative Example 2 showed parts that were not divided along the scribe grooves. From the above, $\Delta$d should be large when the largest groove depth is large but may be small when the largest groove depth is small and an appropriate degree of dividability can be obtained by confining $\Delta$d to the range of 10 $\mu$m $\leq \Delta$d $\leq$ 50 $\mu$m.

The sample substrates of Examples 5 and 6 had a reference thickness of 0.2 mm and those of Examples 7 and 8 had a reference thickness of 0.63 mm. While it was confirmed that a substrate having a small thickness of 0.2 mm can be divided by applying only relatively little force but, in the case of Comparative Example 3, where $\Delta$d is less than 10 $\mu$m, the sample substrate produced cracks at and near the scribes due to the impact of the drop test onto a concrete floor to prove that it involved a problem in terms of operability (easy handling) and yield, although it showed no problem in terms of dividability. On the other hand, the sample substrates having a thickness of 0.63 mm were free from any problem in terms of profile of divided surface, although they resisted to a small extent when they were divided. However, in the case of Comparative Example 4, where $\Delta$d is more than 50 $\mu$m, the broken surfaces of the shallow groove sections showed considerably large undulations that may probably adversely affect the dimensional precision when the substrate is divided.

From the above, it was found that the difference $\Delta$d of depth between the part having the largest depth and the part having the smallest depth of each groove is preferably not less than 10 $\mu$m and not more than 50 $\mu$m. The effect of the resisting parts is reduced when the difference of depth is less than 10 $\mu$m, whereas the substrate may not be divided well when the difference of depth is more than 50 $\mu$m.

(Evaluation Test 2)

The dividability of each sample substrates was evaluated as a function of the reference depth dm, the groove width c, the radius of curvature p of the bottom section and so on. Table 2 shows some of the obtained data. Sintered substrates similar to those employed in Evaluation Test 1 were prepared and scribe grooves similar to those shown in FIG. 1 were formed on each of the sample substrates both in the X direction and in the Y direction by means of a fiber laser that was also similar to the one used for Evaluation Test 1 and the sample substrates were divided along the scribe grooves 21x in the X-direction by hand. Each of the sintered boards was mounted on an XY biaxial table and a laser beam was irradiated onto a constant spot from the fiber laser 7 without using any galvano-mirror 5. The test procedures of Evaluation Test 2 were same as those of Evaluation Text 1 except that the sintered board was moved along the scribe lines in the X-direction to produce scribe grooves 21 having the reference depth dm both in the X-direction and in the Y-direction without forming any shallow groove sections 214 and that scribe grooves 21 of different reference depths dm and groove widths c were produced by varying the irradiation conditions including the laser beam intensity, the spot diameter and the machining speed at every third sintered boards.

In Table 2, each sample No. indicates a group of samples prepared under the same conditions and three sintered boards were divided by hand along nine scribe groves 21x running in the X-direction. The samples were evaluated for dividability by visually observing the instances that were not divided along scribe lines and also the cracks and the burrs that were produced in the divided surfaces. Samples Nos. 1 through 5 were machined to realize a target groove width c of 0.2 mm, samples Nos. 6 through 11 were machined to realize a target groove width c of 0.13 mm, samples Nos. 12 through 17 were machined to realize a target groove width c of 0.1 mm, while samples Nos. 18 through 23 were machined to realize a target groove width c of 0.07 mm and samples Nos. 24 through 29 were machined to realize a target groove width c of 0.05 mm. A laser beam 7 was irradiated onto each of the samples Nos. 30 through 35 while being inclined in the direction of the lateral surface of each scribe grooves so as to displace the position of the deepest part of the groove relative to the center line of the groove width c. The width c1 of the heat-affected zones of each of the samples Nos. 36 through 41 was increased by adjusting the spot diameter and the output power of the irradiated laser beam because, otherwise, the groove width c and the width c1 of the heat-affected zone appear to be substantially same with each other. The width c1 of the heat-affected zone was defined to be that of a zone whose surface oxygen concentration is not less than 5 wt%. Samples Nos. 42 through 46 had a substrate thickness of 0.2 mm and samples Nos. 47 through 50 had a substrate thickness of 0.63 mm. The profile of the scribe grooves of each sample was evaluated by two-dimensionally measuring the profile by means of a laser displacement meter at a position in a scribe groove 21x running through the center of the sintered board in the X-direction and separated by about 10 mm from the crossing of the X scribe groove and a Y scribe groove at the center of the sintered board, which was selected arbitrarily from the three sintered boards on which scribe grooves were formed. When the cross section to be observed is not clear, parameters that express the groove profile were determined from the results of observation of the product whose groove cross section was polished through an optical microscope or a SEM. In Table 2, $\Delta$dm of sample No. 1 was made equal to 52 $\mu$m (0.052 mm). $\Delta$dm was adjusted so as to be within the range of 10 to 50 $\mu$m for all the other samples.

[Table 2]

| Sample No. | B plate thickness | dm value (mm) | p value | c value | e value | c1 value | p/B value | dm/B value | dividability |
|---|---|---|---|---|---|---|---|---|---|
| | microgauge | optimal microscopc ≤ B/2 | value measured by SEM | optical microscope ≤ 0.2 | optimal microscope ≤ c/4 | optical microscope ≤ 1.5C | ≤ 0.3 | 0.1 to 0.5 | expressed by number of detects, number of grooves n = 9 |
| 1 | 0.315 | 0.033 | 0.096 | 0.185 | - | - | 0.305 | 0.105 | 5 |
| 1 | 0.328 | 0.059 | 0.081 | 0.183 | - | - | 0.247 | 0.18 | 0 |
| 3 | 0.324 | 0.112 | 0.098 | 0.179 | - | - | 0.302 | 0.346 | 0 |
| 4 | 0.319 | 0.142 | 0.053 | 0.195 | - | - | 0.166 | 0.445 | 0 |
| 5 | 0.327 | 0.189 | 0.059 | 0.232 | - | - | 0.18 | 0.578 | 0 |
| 6 | 0.308 | 0.028 | 0.085 | 0.124 | - | - | 0.276 | 0.091 | 2 |
| 7 | 0.32 | 0.04 | 0.048 | 0.12 | - | - | 0.15 | 0.125 | 0 |
| 8 | 0.326 | 0.065 | 0.053 | 0.132 | - | - | 0.1.63 | 0.199 | 0 |
| 9 | 0.314 | 0.11 | 0.042 | 0.121 | - | - | 0.134 | 0.35 | 0 |
| 10 | 0.328 | 0.174 | 0.041 | 0.149 | - | - | 0.125 | 0.53 | 0 |
| 11 | 0.316 | 0.212 | 0.029 | 0.168 | - | - | 0.092 | 0.671 | 0 |
| 12 | 0.326 | 0.032 | 0.064 | 0.089 | - | - | 0.196 | 0.098 | 1 |
| 13 | 0.326 | 0.054 | 0.049 | 0.071 | - | - | 0.15 | 0.166 | 0 |
| 14 | 0.328 | 0.082 | 0.028 | 0.092 | - | - | 0.085 | 0.25 | 0 |
| 15 | 0.317 | 0.123 | 0.031 | 0.11 | - | - | 0.098 | 0.388 | 0 |
| 16 | 0.321 | 0.149 | 0.017 | 0.0098 | - | - | 0.053 | 0.464 | 0 |
| 17 | 0.319 | 0.178 | 0.022 | 0.11 | - | - | 0.069 | 0.558 | 0 |
| 18 | 0.321 | 0.028 | 0.031 | 0.049 | - | - | 0.097 | 0.087 | 2 |
| 19 | 0.331 | 0.038 | 0.019 | 0.061 | - | - | 0.057 | 0.115 | 0 |
| 20 | 0.327 | 0.061 | 0.011 | 0.054 | - | - | 0.034 | 0.187 | 0 |
| 21 | 0.329 | 0.093 | 0.009 | 0.063 | - | - | 0.027 | 0.283 | 0 |

Note: groove profile after laser machining

| Sample No. | groove profile after laser machining | | | | | | | | dividability |
|---|---|---|---|---|---|---|---|---|---|
| | B plate thickness | dm value (mm) | p value | c value | e value | c1 value | p/B value | dm/B value | expressed by number of detects |
| | microgauge | optimal microscopc ≤ B/2 | value measured by SEM | optical microscope ≤ 0.2 | optimal microscope ≤ c/4 | optical microscope ≤ 1.5C | ≤ 0.3 | 0.1 to 0.5 | number of grooves n = 9 |
| 22 | 0.318 | 0.164 | 0.008 | 0.072 | - | - | 0.025 | 0.516 | 0 |
| 23 | 0.314 | 0.213 | 0.015 | 0.079 | - | - | 0.048 | 0.678 | 0 |
| 24 | 0.312 | 0.024 | 0.021 | 0.029 | - | - | 0.067 | 0.077 | 3 |
| 25 | 0.322 | 0.039 | 0.019 | 0.047 | - | - | 0.059 | 0.121 | 0 |
| 26 | 0.32 | 0.081 | 0.011 | 0.038 | - | - | 0.034 | 0.253 | 0 |
| 27 | 0.325 | 0.117 | 0.009 | 0.045 | - | - | 0.028 | 0.36 | 0 |
| 28 | 0.317 | 0.154 | 0.008 | 0.027 | - | - | 0.025 | 0.486 | 0 |
| 29 | 0.324 | 0.223 | 0.009 | 0.028 | - | - | 0.028 | 0.688 | 0 |
| 30 | 0.318 | 0.053 | 0.061 | 0.14 | 0.067 | - | 0.192 | 0.167 | 1 |
| 31 | 0.326 | 0.067 | 0.049 | 0.135 | 0.054 | - | 0.15 | 0.206 | 0 |
| 32 | 0.319 | 0.069 | 0.054 | 0.132 | 0.03 | - | 0.169 | 0.216 | 0 |
| 33 | 0.316 | 0.1161 | 0.041 | 0.138 | 0.029 | - | 0.13 | 0.193 | 0 |
| 34 | 0.327 | 0.055 | 0.043 | 0.136 | 0.015 | - | 0.131 | 0.168 | 0 |
| 35 | 0.321 | 0.061 | 0.035 | 0.127 | 0.011 | - | 0.109 | 0.19 | 0 |
| 36 | 0.326 | 0.069 | 0.053 | 0.093 | - | 0.156 | 0.163 | 0.212 | 0 |
| 37 | 0.321 | 0.056 | 0.049 | 0.105 | - | 0.163 | 0.153 | 0.174 | 0 |
| 38 | 0.318 | 0.064 | 0.046 | 0.092 | - | 0.17 | 0.145 | 0.201 | 0 |
| 39 | 0.316 | 0.067 | 0.041 | 0.114 | - | 0.131 | 0.13 | 0.212 | 0 |
| 40 | 0.321 | 0.082 | 0.132 | 0.103 | - | 0.12 | 0.1 | 0.255 | 0 |
| 41 | 0.318 | 0.075 | 0.046 | 0.092 | - | 0.129 | 0.145 | 0.236 | 0 |
| 42 | 0.198 | 0.011 | 0.031 | 0.041 | - | - | 0.157 | 0.056 | 3 |

EP 2 315 508 B1

| Sample No. | groove profile after laser machining | | | | | | | | dividability |
|---|---|---|---|---|---|---|---|---|---|
| | B plate thickness | dm value (mm) | p value | c value | e value | c1 value | p/B value | dm/B value | expressed by number of detects |
| | microgauge | optimal microscopc ≤ B/2 | value measured by SEM | optical microscope ≤ 0.2 | optimal microscope ≤ c/4 | optical microscope ≤ 1.5C | ≤ 0.3 | 0.1 to 0.5 | number of grooves n = 9 |
| 43 | 0.206 | 0.037 | 0.019 | 0.061 | - | - | 0.092 | 0.18 | 0 |
| 44 | 0.202 | 0.069 | 0.011 | 0.054 | - | - | 0.054 | 0.342 | 0 |
| 45 | 0.195 | 0.081 | 0.009 | 0.063 | - | - | 0.046 | 0.415 | 0 |
| 46 | 0.207 | 0.135 | 0.008 | 0.072 | - | - | 0.039 | 0.652 | 0 |
| 47 | 0.636 | 0.124 | 0.062 | 0.126 | - | - | 0.097 | 0.195 | 0 |
| 48 | 0.645 | 0.183 | 0.045 | 0.137 | - | - | 0.07 | 0.284 | 0 |
| 49 | 0.627 | 0.251 | 0.031 | 0.166 | - | - | 0.049 | 0.4 | 0 |
| 50 | 0.649 | 0.358 | 0.029 | 0.182 | - | - | 0.045 | 0.552 | 0 |

EP 2 315 508 B1

As shown in Table 2, division defects were observed in samples No. 1, 6, 12, 18, 24, 30 and 42 that characteristically showed a large p/B value and a small dm/B value if compared with other samples that were machined to show a same groove width. Seeing that sample No. 1 showed many defects in particular, it is preferable to make dm/B not less than 0.1 and p/B not more than 0.3 to reduce division defects.

It seems that sample No. 30 was influenced to a large extent by the quantity of positional displacement e from the center of the groove width of the deepest part of each groove. For this reason, it is preferable to make the quantity of positional displacement e from the center not more than c/4. While only the e values and the c1 values of the samples that were machined under special conditions of irradiation in order to see the influence of e or c1 were shown in Table 2, the inventor confirmed that the c1 values and the e values of all the other samples were found to be not more than 1. 5c and not more than c/4 respectively as a result of observing the randomly picked up samples.

The samples whose dm/B values exceeded 0.5 gave a feeling that they could be inadvertently broken when it is being handled in a metal plate bonding step or some other step. Therefore, it is preferable to make the dm/B value not more than 0.5. Of samples Nos. 36 through 41, those having a heat-affected zone width c1 not less than 1.5c seem to be influenced by the c1 value in terms of dimensional precision and bending strength of the ceramic substrates from them and dielectric strength of the circuit substrates produced from them. While substrates having a small thickness of about 0.2 mm such as samples Nos. 42 through 50 can be machined highly accurately by reducing the c value, 0.13 mm seem to be the smallest permissible value of c as viewed from the results of this evaluation test particularly when a satisfactory dividability level needs to be secured for thicker substrates having a thickness as large as 0.63 mm. A focusing lens of a smaller focal length may be required to further reduce the c value.

(Evaluation Test 3)

The qualities of ceramic substrates produced from different scribe groove profiles were evaluated. Table 3 shows some of the obtained data. After the evaluation test 2, the sintered boards were divided along the X-direction to produce oblong sintered boards, which were then divided by hand along the scribe grooves 21y running in the Y-direction to produce ceramic substrates. Then, the produced ceramic substrates were observed for dimensional precision, bending strength, the arithmetic mean roughness Ra of the divided surfaces and so on. The sample Nos. in Table 3 correspond to the sample Nos. in Table 2 and hence a sample in Table 3 is a ceramic substrate produced from or prepared under the same conditions as the sintered board of the same sample No. As for evaluation of dimensional precision, the dimensions of the twelve ceramic substrates (dimensions: 50 × 40 mm, tolerance of dimension: ±0.1 mm) produced from a sintered board were measured by a vernier caliper to computationally determine the process capability. As for evaluation of bending strength, a test piece that had dimensions as described above was prepared separately and evaluated.

As for measurement of roughness of divided surface, one of the divided surfaces at a position where the groove profile was observed in Evaluation Test 2 was observed for surface roughness. The laser-machined surface was measured at and near the center part of the reference groove depth dm in a longitudinal direction (direction of 220) and the broken surface was measured at and near the center part of the depth of the broken surface in a longitudinal direction (direction of 220), whereas the break line was measured at and near the boundary section of the laser-machined surface and the broken surface.

[Table 3]

| Sample No | B Board Thickness (mm) Micro-gauge | Groove profile after laser machining (representative value) | | | | | ρ/B ≤0.3 | dm/B 0.1~0.5 | Dimensional precision Process capability ≥1.3 Tolerance±0.1 | Bending strength Fall ratio ≤5% (%) | Surface roughness of laser-machined surfaces and broken surface Laser-machined surface Arithmetic average roughness Ra2 (μm) | Broken surface Arithmetic average roughness Ra1 (μm) | Undulations of broken surface (μm) |
|---|---|---|---|---|---|---|---|---|---|---|---|---|---|
| | | dm (mm) Optical Microscope ≤B/2 | ρ (mm) Measured by SEM | c (mm) Optical Microscope ≤0.2 | e (mm) Optical Microscope ≤c/4 | cl (mm) Optical Microscope ≤1.5c | | | | | | | |
| 1 | 0.315 | 0.033 | 0.006 | 0.185 | - | - | 0.306 | 0.105 | - | - | - | - | - |
| 2 | 0.328 | 0.059 | 0.081 | 0.183 | - | - | 0.247 | 0.160 | 1.7 | 1.5 | 1.1 | 4.6 | 9 |
| 3 | 0.324 | 0.112 | 0.098 | 0.172 | - | - | 0.302 | 0.346 | 1.9 | 2.3 | 0.7 | 3.2 | 13 |
| 4 | 0.319 | 0.142 | 0.053 | 0.195 | - | - | 0.166 | 0.445 | 2.2 | 2.9 | 0.5 | 2.8 | 11 |
| 5 | 0.327 | 0.189 | 0.059 | 0.232 | - | - | 0.180 | 0.578 | 0.9 | 6.8 | 0.3 | 0.6 | 20 |
| 6 | 0.308 | 0.028 | 0.005 | 0.124 | - | - | 0.276 | 0.091 | - | - | - | - | - |
| 7 | 0.320 | 0.040 | 0.048 | 0.120 | - | - | 0.150 | 0.125 | 1.5 | 0.8 | 1.2 | 4.9 | 8 |
| 8 | 0.326 | 0.065 | 0.053 | 0.132 | - | - | 0.163 | 0.199 | 1.6 | 0.5 | 0.8 | 3.8 | 11 |
| 9 | 0.314 | 0.110 | 0.042 | 0.121 | - | - | 0.134 | 0.350 | 1.4 | 1.1 | 0.7 | 5.4 | 14 |
| 10 | 0.328 | 0.174 | 0.041 | 0.143 | - | - | 0.125 | 0.530 | 0.9 | 7.8 | 0.8 | 3.1 | 15 |
| 11 | 0.316 | 0.212 | 0.029 | 0.168 | - | - | 0.092 | 0.671 | 0.7 | 8.2 | 1.0 | 4.5 | 17 |
| 12 | 0.326 | 0.032 | 0.064 | 0.088 | - | - | 0.198 | 0.093 | - | - | - | - | - |
| 13 | 0.326 | 0.054 | 0.049 | 0.071 | - | - | 0.150 | 0.166 | 1.8 | 0.5 | 0.9 | 4.7 | 7 |
| 14 | 0.328 | 0.082 | 0.028 | 0.092 | - | - | 0.085 | 0.250 | 2.1 | 0.3 | 1.1 | 4.2 | 10 |
| 15 | 0.317 | 0.123 | 0.031 | 0.110 | - | - | 0.098 | 0.388 | 1.4 | 2.2 | 0.6 | 5.1 | 9 |
| 16 | 0.321 | 0.149 | 0.017 | 0.093 | - | - | 0.053 | 0.464 | 1.9 | 4.2 | 0.4 | 3.8 | 12 |
| 17 | 0.319 | 0.178 | 0.022 | 0.110 | - | - | 0.069 | 0.558 | 1.4 | 6.4 | 0.9 | 6.2 | 16 |
| 18 | 0.321 | 0.028 | 0.031 | 0.043 | - | - | 0.097 | 0.087 | - | - | - | - | - |
| 19 | 0.331 | 0.038 | 0.019 | 0.081 | - | - | 0.057 | 0.115 | 2.6 | 1.2 | 0.8 | 3.4 | 11 |
| 20 | 0.327 | 0.061 | 0.011 | 0.054 | - | - | 0.034 | 0.187 | 2.7 | 0.9 | 0.6 | 2.9 | 13 |
| 21 | 0.329 | 0.093 | 0.009 | 0.063 | - | - | 0.027 | 0.283 | 2.2 | 2.2 | 0.5 | 3.6 | 10 |
| 22 | 0.318 | 0.164 | 0.008 | 0.072 | - | - | 0.025 | 0.516 | 2.5 | 5.2 | 0.7 | 6.2 | 18 |
| 23 | 0.314 | 0.213 | 0.015 | 0.079 | - | - | 0.048 | 0.678 | 2.1 | 6.4 | 0.8 | 5.3 | 14 |
| 24 | 0.312 | 0.024 | 0.021 | 0.029 | - | - | 0.067 | 0.077 | - | - | - | - | - |
| 25 | 0.322 | 0.039 | 0.019 | 0.047 | - | - | 0.059 | 0.121 | 2.6 | 0.2 | 0.5 | 5.1 | 12 |
| 26 | 0.320 | 0.081 | 0.011 | 0.038 | - | - | 0.034 | 0.253 | 2.5 | 0.9 | 0.7 | 3.7 | 14 |
| 27 | 0.325 | 0.117 | 0.009 | 0.045 | - | - | 0.028 | 0.360 | 2.9 | 1.6 | 0.9 | 4.5 | 10 |
| 28 | 0.317 | 0.154 | 0.008 | 0.027 | - | - | 0.025 | 0.486 | 3.1 | 4.5 | 0.5 | 5.5 | 15 |
| 29 | 0.324 | 0.223 | 0.009 | 0.028 | - | - | 0.028 | 0.688 | 2.8 | 5.8 | 1.1 | 4.8 | 17 |
| 30 | 0.318 | 0.053 | 0.061 | 0.140 | 0.087 | - | 0.192 | 0.167 | - | - | - | - | - |
| 31 | 0.326 | 0.067 | 0.049 | 0.135 | 0.054 | - | 0.150 | 0.206 | 0.5 | 1.2 | - | - | - |
| 32 | 0.319 | 0.069 | 0.054 | 0.132 | 0.030 | - | 0.169 | 0.216 | 1.5 | 0.8 | - | - | - |
| 33 | 0.316 | 0.061 | 0.041 | 0.138 | 0.029 | - | 0.130 | 0.193 | 1.3 | 1.5 | - | - | - |
| 34 | 0.327 | 0.055 | 0.043 | 0.136 | 0.015 | - | 0.131 | 0.168 | 1.6 | 2.1 | - | - | - |
| 35 | 0.321 | 0.061 | 0.035 | 0.127 | 0.011 | - | 0.109 | 0.190 | 1.3 | 1.8 | - | - | - |
| 36 | 0.326 | 0.069 | 0.053 | 0.093 | - | 0.156 | 0.163 | 0.212 | 0.7 | 2.2 | - | - | - |
| 37 | 0.321 | 0.056 | 0.049 | 0.105 | - | 0.163 | 0.153 | 0.174 | 0.8 | 2.9 | - | - | - |
| 38 | 0.318 | 0.064 | 0.046 | 0.092 | - | 0.170 | 0.145 | 0.201 | 0.5 | 5.2 | - | - | - |
| 39 | 0.316 | 0.067 | 0.041 | 0.114 | - | 0.131 | 0.130 | 0.212 | 1.4 | 1.9 | - | - | - |
| 40 | 0.321 | 0.082 | 0.032 | 0.103 | - | 0.120 | 0.100 | 0.255 | 1.5 | 2.3 | - | - | - |
| 41 | 0.318 | 0.075 | 0.046 | 0.092 | - | 0.129 | 0.145 | 0.236 | 1.3 | 1.4 | - | - | - |
| 42 | 0.198 | 0.011 | 0.031 | 0.041 | - | - | 0.157 | 0.056 | - | - | - | - | - |
| 43 | 0.206 | 0.037 | 0.010 | 0.061 | - | - | 0.092 | 0.180 | 1.5 | 0.6 | 0.6 | 2.1 | 12 |
| 44 | 0.202 | 0.069 | 0.011 | 0.054 | - | - | 0.054 | 0.342 | 1.9 | 1.3 | 0.5 | 4.1 | 14 |
| 45 | 0.195 | 0.081 | 0.009 | 0.063 | - | - | 0.046 | 0.415 | 1.8 | 4.1 | 0.7 | 3.4 | 9 |
| 46 | 0.207 | 0.135 | 0.008 | 0.072 | - | - | 0.039 | 0.652 | 2.2 | 7.2 | 0.8 | 2.8 | 18 |
| 47 | 0.636 | 0.124 | 0.062 | 0.126 | - | - | 0.097 | 0.195 | 1.4 | 0.9 | 0.8 | 3.4 | 13 |
| 48 | 0.645 | 0.183 | 0.045 | 0.137 | - | - | 0.070 | 0.284 | 1.5 | 2.2 | 1.4 | 4.1 | 15 |
| 49 | 0.627 | 0.251 | 0.031 | 0.166 | - | - | 0.049 | 0.400 | 1.4 | 3.8 | 1.1 | 5.8 | 18 |
| 50 | 0.649 | 0.358 | 0.029 | 0.182 | - | - | 0.045 | 0.552 | 0.8 | 6.5 | 1.8 | 3.6 | 20 |

As for rating of dimensional precision, a substrate showing a process capability of not less than 1.3 with a tolerance of ±0.1 mm was rated as excellent. As for bending strength, a substrate showing a fall ratio of not more than 5% was rated as permissible. Process capability (Cpk) is an index of ability of producing products within predefined specification limits and expressed by the formula shown below, where Su is the upper specification limit value, S1 is the lower specification limit value, μ is the average value and σ is the standard deviation, and a process capability of not less than 1.3 (1.33 to be more accurate but 1.3 is employed for the purpose of the present embodiment) is generally employed for quality guarantee:

$$\text{Cpk} = \min \left[ (\text{Su} - \mu) / 3\sigma, (\mu - \text{Sl}) / 3\sigma \right],$$

where min [ ] is the function for returning the smallest value in the parenthesis.

When evaluating the process capability for dimensional precision, twelve was used for the N number for the machining conditions of each sample No. A process capability Cpk: 1.33 means that the defect ratio is about 60 ppm in a same lot and hence suggests that the evaluated process is feasible for mass production.

Bending strength refers to 4-point bending strength as described earlier and the conducted test conformed to the specifications of the bending strength test for fine ceramic (JIS R1601) except the test pieces had dimensions of length: 40 mm × width; 10 mm × thickness: 0.32 mmt.

From Table 3, it will be seen that a sample showing a large dm/B value also showed a large bending strength fall ratio among the samples of Nos. 1 through 29 and Nos. 42 through 50. This is because as the groove depth dm increases, the quantity of the thermal energy of the laser beam irradiated onto the substrate increases to give a large thermal damage to the substrate. By seeing samples Nos. 5, 10, 11, 17, 22, 23, 29, 46 and 50, it will be understood that the samples showing a bending strength fall ratio of not less than 5% showed a dm/B value of not less than 0.5. The process capabilities of samples Nos. 5, 10, 11 and 50 were low because these samples had a groove width c that is greater than the target groove width. From these, it will be understood that it is important to make dm/B of each scribe groove not more than 0.5 and the groove width c not more than 0.2 mm and substrates need to be machined accurately so as to realize the standard dimensions. Sample No. 31 also showed a low process capability and had a large e value. As pointed out above, defective divisions arose to sample No. 30 and had a large e value. Thus, considering that the e value is preferably small and seeing that the process capabilities of samples Nos. 33 and 35 were 1.3, which is the permissible limit value, it will be safe to say that the e value is preferably not more than c/4. Samples Nos. 36, 37 and 38 showed a low process capability and sample No. 38 also showed a poor bending strength fall ratio. Seeing that theses samples showed a c1 value that is 1.6 to 1.8 times of the c value and the c1 values of samples Nos. 39 through 41 other than the above listed samples were not more than 1.4 times of the c value, it will be safe to say that c1 is preferably not more than 1.5 times of the corresponding c value. When a thick substrate such as sample No. 50 was divided, the broken sections showed a large thickness and the substrate tended to show a low process capability and a high broken surface roughness Ra1 if compared with a thin substrate. While the results of experiment obtained from the substrates machined under only part of the machining conditions are listed here, it will be safe to assume that the groove width c is desirably minimized in order to ensure a satisfactory level of dimensional precision when preparing circuit substrate from a thick plate made of a material showing a high fracture toughness such as silicon nitride.

Thus, it is possible to provide a ceramic substrate showing a satisfactory level of dimensional precision with a tolerance of ±0.1 mm, a process capability (Cpk) of not less than 1. 3 and a bending strength fall ratio of not more than 5% by selecting appropriate conditions in a manner as described above.

By comparing the arithmetic surface roughness Ra2 of the laser-machined surface and the arithmetic surface roughness Ra1 of the broken surface of a divided surface, it will be seen that the largest value of Ra2 is 1.2 μm as found in sample No. 7 and the smallest value of Ra1 is 2.8 μm as found in sample No. 4 out of all the data of the samples having a substrate thickness of 0.32 mm to prove that Ra2 is clearly smaller than Ra1. The heights of undulations fr of the break line were mostly not more than 20 μm to prove that the substrates were substantially smooth. Thus, when the surface roughness of the laser-machined surface and that of the broken surface show only a small difference and the height of undulations of the break line is small, the number of factors that can operate as starting points of micro-cracks is reduced and a good dividability is achieved. Additionally, if the brazing material for bonding a metal plate adheres to such a divided surface, the brazing material can be removed with ease. The largest difference between Ra1 and Ra2 of a sample was 5.8 μm as found in sample No. 5 and the difference exceeds 5 μm in samples Nos. 17 and 22. Seeing that these samples also showed a large bending strength fall ratio, it will be safe to say that the difference between Ra1 and Ra2 on a divided surface is preferably not more than 5 μm and the permissible range may be defined to be not more than 10 μm from the results of the comparison test that will be described below. Similarly, the height of undulations of a break line is preferably not more than 15 μm from the viewpoint of bending strength fall ratio and process capability and the permissible range may be defined to be not more than 20 μm from the results of the comparison test that will be described below.

(Comparison Test)

For the purpose of comparison, sintered substrates similar the above-described ones were prepared and discontinuous holes are formed there by $CO_2$ laser machining to evaluate the dividability and the quality of each of the samples by way of evaluation tests 1 and 2 that were similar to the above-described ones. Some of the obtained data are shown in Table 4. The scribe holes were made to show a relatively large depth d' so as to make the ceramic substrates of the samples easily separable. The hole diameter c' was also made larger than the ordinary hole diameter by about 10 to 30 $\mu$m and holes were formed more densely than those of ordinary substrates. Samples Nos. 51 through 53 were machined to show a hole diameter c' that correspond to a groove width of 0.13 mm and samples Nos. 54 through 55 were machined to show a hole diameter c' that corresponds to a groove width of 0.07 mm. Similarly, samples with a substrate thickness of 0.2 mm and those with a substrate thickness of 0.63 mm were prepared with different hole diameters c' and different hole depths d' for evaluation.

[Table 4]

| Sample No | B Board Thickness (mm) Micro-gauge | d' hole depth (mm) Optical Microscope | ρ' radius of curvature of hole bottom (mm) Measured by SEM | c' hole diameter (mm) Optical Microscope | Hole pitch (mm) Optical Microscope | ρ'/B | d'/B | Dividability Expressed by number of defects Number of grooves n=9 | Dimensional precision Process capability ≥1.3 Tolerance±0.1 | Bending strength Fall rate (N) | Laser-machined surface Arithmetic average roughness Ra2 (μm) | Broken surface Arithmetic average roughness Ra1 (μm) |
|---|---|---|---|---|---|---|---|---|---|---|---|---|
| 51 | 0.326 | 0.167 | 0.018 | 0.132 | 0.162 | 0.055 | 0.512 | 0 | 0.3 | 12.1 | 30.9 | 5.6 |
| 52 | 0.315 | 0.135 | 0.021 | 0.130 | 0.143 | 0.067 | 0.429 | 0 | 0.7 | 5.2 | 32.6 | 6.7 |
| 53 | 0.328 | 0.138 | 0.015 | 0.126 | 0.138 | 0.046 | 0.421 | 0 | 0.6 | 6.1 | 24.8 | 4.8 |
| 54 | 0.327 | 0.125 | 0.011 | 0.067 | 0.082 | 0.034 | 0.382 | 0 | 1.3 | 5.4 | 16.8 | 3.8 |
| 55 | 0.324 | 0.119 | 0.013 | 0.072 | 0.085 | 0.040 | 0.367 | 1 | - | - | - | - |
| 56 | 0.199 | 0.110 | 0.012 | 0.122 | 0.145 | 0.060 | 0.553 | 0 | 0.8 | 14.8 | 32.7 | 8.6 |
| 57 | 0.206 | 0.091 | 0.012 | 0.105 | 0.123 | 0.058 | 0.442 | 0 | 1.0 | 9.5 | 26.1 | 7.8 |
| 58 | 0.195 | 0.088 | 0.014 | 0.091 | 0.105 | 0.072 | 0.441 | 0 | 1.1 | 7.6 | 21.8 | 3.4 |
| 59 | 0.198 | 0.080 | 0.010 | 0.076 | 0.089 | 0.051 | 0.404 | 0 | 1.4 | 6.6 | 15.6 | 4.1 |
| 60 | 0.202 | 0.069 | 0.009 | 0.051 | 0.068 | 0.045 | 0.342 | 1 | - | - | - | - |
| 61 | 0.633 | 0.367 | 0.042 | 0.153 | 0.172 | 0.066 | 0.580 | 0 | 0.5 | 21.2 | 54.8 | 9.2 |
| 62 | 0.619 | 0.307 | 0.026 | 0.131 | 0.144 | 0.042 | 0.496 | 0 | 0.8 | 13.7 | 47.5 | 8.4 |
| 63 | 0.648 | 0.275 | 0.035 | 0.102 | 0.127 | 0.054 | 0.424 | 0 | 0.9 | 8.1 | 34.1 | 5.9 |
| 64 | 0.651 | 0.245 | 0.031 | 0.097 | 0.122 | 0.048 | 0.376 | 0 | 0.9 | 5.1 | 22.4 | 6.7 |
| 65 | 0.614 | 0.198 | 0.029 | 0.086 | 0.103 | 0.047 | 0.322 | 2 | - | - | - | - |

Groove profile after laser machining (representative value)

The d' /B values that correspond to the d/B values of scribe grooves were large as a whole and 0.367 to 0.512, 0.342 to 0.553 and 0.322 to 0.580 respectively for the thicknesses of 0.32 mm, 0.2 mm and 0.63 mm, whereas the p' /B values that correspond to the p/B values were very small and about 0.05. As for dividability, all the samples showed a good dividability except that one from each of samples Nos. 55 and 60 and two from sample No. 65 were defects in terms of dividability. However, the d' /B values of these defect samples were 0.367, 0.342 and 0.322, meaning that no defect would have been produced if scribe grooves were used. From the above, it will be seen that sintered boards may advantageously be laser-machined to produce scribe lines of relatively shallow continuous grooves 21 rather than to produce those of deep and discontinuous holes. If discontinuous holes are formed in an overlapping manner, they cannot replace continuous grooves because the latter may have only a small depth and the pitch of arrangement thereof may well be incomparably small. As for the quality of the ceramic substrates produced by dividing the samples, all the ceramic substrates did not satisfy both the predefined permissible value for process capability and the one for bending strength fall ratio except that the process capabilities of samples Nos. 54 and 59 were not less than 1.3 and narrowly reached the permissible level. This is probably because the surface roughness of a divided surface from the line formed by deep discontinuous holes is specifically attributable to the surface roughness of the laser-machined surfaces of the holes. This will be evidenced from the fact that the Ra1 values of the broken surfaces produced from discontinuous holes were substantially equal to those of the broken surfaces produced from scribed continuous grooves, whereas the Ra2 values of the laser-machined surfaces produced from discontinuous holes were several times to tens of several times larger than those of the laser-machined surfaces produced from scribed continuous grooves and the relationship of Ra1 < Ra2 was constantly maintained as seen from the results of measurement of the arithmetic mean roughness Ra of the laser-machined surface and that of the broken surface of each divided surface. With regard to strength fall, stress is highly concentrated on the divided surfaces of each of the samples due to the effect of semicircular notches produced to the divided sections after dividing the sample along the discontinuous holes and such a high stress concentration may have affected to the strength falls. Thus, by forming scribe lines by means of continuous scribe grooves on a substrate according to the present invention instead of forming scribe lines by means of scribe holes according to the prior art, the substrate can be divided satisfactorily with shallow grooves and shows a low surface coarse on the divided surfaces, the laser-machined surfaces in particular, to ensure a high product quality. As for the machining time for producing a scribe line, the longest machining time of the samples Nos. 51 through 53 was more than ten times than the machining time according to the present invention and the shortest machining time of samples Nos. 54 through 55 was about five times of the machining time according to the present invention. Thus, the method of producing scribe lines according to the present invention can remarkably reduce the machining time and reduce the manufacturing cost.

From the above, the present invention can reduce the size of each heat-affected zone and also the area of each surface oxide region and minimize molten and scattering objects at and near grooves if compared with the prior art of using a YAG laser or a $CO_2$ laser for producing discontinuous holes. Thus, the present invention provides a method of producing continuous scribe grooves with a machining time less than 1/2 than that of the prior art for producing comparable discontinuous grooves.

(Evaluation Test 4)

The copper circuit substrates 12 prepared by using the ceramic substrates of Evaluation Tests 1 through 3 and having a substrate thickness of 0.32 mm were evaluated for product quality.

To begin with, circuit substrates 12 prepared by using the laser-machined ceramic substrates 1 under the conditions of samples Nos. 9, 14, 21 and 28 and sample No. 52, which was used as comparative example, were evaluated for dielectric strength. Note that the ceramic circuit substrates 12 were prepared in the following manner.

Firstly, when forming scribe lines by laser machining, alignment through holes (ø0.2 mm) for operating as printing guide holes were cut through by means of a laser so that the printing patterns of a brazing material to be formed respectively on front and rear surfaces of each of the assembled board 10, which will be described in detail hereinafter, may not be displaced relative to each other at the time of screen mask printing. After the laser machining operation, the assembled boards 10 were subjected to a liquid honing process and washed. Subsequently, for each of the ceramic assembled boards 10, patterns of an active metal brazing material were printed respectively on the front and rear surfaces thereof by referring to the above-described common holes. Thereafter, a 0. 6 mm-thick copper circuit plates was bonded to one of the surfaces while a 0.5 mm-thick copper heat sink plate was bonded to the other surface of the ceramic assembled board. The copper plates were bonded in a vacuum furnace by means of an active metal brazing method in the bonding process. After ensuring that the bonded assembly was free from large voids by means of an ultrasonic microscope, film resist was applied to the copper plates to form a pattern 3 on the metal circuit plate and a pattern 4 on the metal heat sink plate and exposed to light and developed to produce the resist patterns. Thereafter, the copper metal patterns 3 and 4 were produced by wet etching, using an iron chloride solution. Then, a palladium catalyst was applied by way of a step of removing the resist and the unnecessary brazing material and a acid washing and chemical polishing step. After the palladium was applied, palladium at the positions where plating was unnecessary was removed by immersion in an acidic solution and the surfaces of the copper metal patterns 3, 4 were plated by Ni-P electroless plating. Finally, the assembled board 10 was divided along the scribe grooves 21 to produce individual ceramic circuit substrates 12. Although not described in detail, a dummy metal pattern may be formed in the non-product region 2 of the assembled board 10 as counter-void measure during the brazing/bonding process before forming the circuit substrates.

The circuit substrates were evaluated for dielectric strength in a manner as described below. The circuit substrates were dried at 80°C for 1 hour and thereafter an alternative voltage was applied between the metal circuit plate 3 and the metal heat sink 4 of each of the circuit substrates 12 in insulating oil (silicon oil or Fluorinert, 20°C) and gradually raised from 0 to 10 kV. The dielectric strength voltage performance was evaluated by the voltage value observed when dielectric breakdown took place to the circuit substrate. Thus, a circuit substrate showing a higher dielectric breakdown voltage was a product that was more excellent in terms of dielectric strength voltage performance. The evaluated circuit substrates were those of sample Nos. 9, 14, 21, 28 and 52 and a total of 12 circuit substrates were evaluated for each of the samples.

[Table 5]

| Sample No | Groove profile after laser machining (representative value) | | | | Surface roughness of laser-machined surface and broken surface | | Breakdown characteristics | |
| | B plate thickness (mm) Micro-gauge | dm (mm) Optical microscope | ρ (mm) Measured by SEM | c (mm) Optical microscope | Laser-machined surface Arithmetic average roughness Ra2 (μm) | Broken surface Arithmetic average roughness Ra1 (μm) | Breakdown voltage kV AC | Breakdown category |
|---|---|---|---|---|---|---|---|---|
| 9 | 0.314 | 0.110 | 0.042 | 0.121 | 0.7 | 5.4 | 9.1~9.7 | Breakdown through substrate |
| 14 | 0.328 | 0.082 | 0.028 | 0.092 | 1.1 | 4.2 | 8.2~9.5 | Breakdown through substrate |
| 21 | 0.329 | 0.093 | 0.009 | 0.063 | 0.5 | 3.6 | 8.7~9.5 | Breakdown through substrate |
| 28 | 0.317 | 0.154 | 0.008 | 0.027 | 0.5 | 5.5 | 8.2~8.8 | Breakdown through substrate |
| 52 | 0.315 | 0.135 | 0.021 | 0.130 | 32.6 | 6.7 | 5.4~8.3 | Creeping breakdown observed |

All the ceramic circuit substrates produced from the sample substrates of Examples where scribe grooves 21 were formed by means of a fiber laser for division showed a dielectric breakdown voltage of not less than AC 8 kV so that they could be rated as excellent. Their dielectric breakdown categories were all breakdown through ceramic substrate 1 and no creeping breakdown was observed. On the other hand, while some of the ceramic substrates produced from the sample substrates of Comparative Examples showed a high dielectric breakdown voltage of not less than 8 kV, others showed a dielectric breakdown voltage of only about 5 kV. The dielectric breakdown category of those dielectrically defective substrates was creeping breakdown, which is by no means permissible to ceramic circuit substrates in terms of dielectric strength voltage performance.

The inventor assumes that the cause of this defect includes the influence of the residue such as the objects scattered by the laser and adhering to and near the end facets of the substrate and the brazing material at the end facets and the degraded dielectric effect due to the palladium that penetrated into the discontinuous scribe holes in the circuit substrate producing step and was not removed sufficiently to consequently give rise to a plating effect on the lateral surfaces of the ceramic substrate. Seeing the defect, a low surface roughness of the laser-machined surfaces and a small difference between the surface roughness of the laser-machined surfaces and that of the broken surfaces are advantageous for the dielectric strength voltage performance of the substrate.

From the above, a circuit substrate formed by laser machining so as to be able to control the surface roughness thereof can suppress generation of voids at the brazing material bonding interface of the metal circuit plate and at that of the metal heat sink and adhesion of brazing material to the substrate end facets. Thus, the present invention can provide a ceramic circuit substrate that shows an excellent dielectric strength of not less than 8 kV.

While sintered silicon nitride was employed as ceramic material in the above-described evaluation test in order to ensure the advantages of using silicon nitride that is strong and hard, aluminum nitride or alumina may alternatively be employed to provide comparable effects.

Industrial Applicability

The present invention can find industrial applications in the field of power devices for controlling a large electric current and a high voltage such as industrial inverters and converters for electric automobiles, hybrid automobiles, railway vehicles and power plants. Specific applications include circuit substrates for power semiconductor modules (e.g., IGBT modules). The present invention can also find industrial applications in the field of power devices using a novel semiconductor that can operate at high temperature (not lower than 300°C) such as SiC and GaN that can replace Si.

Explanation of Reference Symbols

1: ceramic substrate
2: non-product region
3: metal circuit plate
4: metal heat sink
5: galvano-mirror
6: focusing lens
7: fiber laser beam
10: ceramic assembled board
11: sintered silicon nitride board (sintered board)
12: ceramic circuit substrate
20: scribe line
21: scribe groove
30: raised area due to molten adhering objects
220: surface roughness measuring direction
211: laser-machined surface (machined surface of continuous grooves)
212: broken surface (surface of broken section)
213: break line
214: shallow groove section

**Claims**

1. A ceramic assembled board(10) with continuous dividing grooves (21) **on a main surface** of a sintered ceramic board by way of laser machining to produce a large number of circuit substrates,

at least one of the continuous **dividing** grooves (21) has a largest depth section and a smallest depth section with a depth difference $\Delta d$ of 10 $\mu$ m$\leq \Delta d \leq$ 50 $\mu$m,

and $\rho/B\leq$ 0.3 within the range of 0.1 $\leq$ dm/B $\leq$ 0.5, **characterized in that**,

**the continuous dividing grooves(21) are formed on only one of the main surfaces, and are not formed on another of the main surfaces,**

here, the radius of curvature of the bottom section is p at any arbitrarily taken cross section of the continuous **dividing** grooves (21), the maximum groove depth is dm, and the board thickness is B in a cross section taken at the largest depth part of the **continuous dividing** grooves (21).

2.   The ceramic assembled board (10) according to claim 1, **wherein,** 0.053$\leq\rho$/B 0.3.

3.   The ceramic assembled board (10) according to claim 1 or 2, **wherein,**
dm is not greater than B/2, the groove width c is not greater than 0.2 mm and the width c1 of the heat-affected zones formed at The opposite sides of the grooves is not greater than 1.5 times of the groove width c.

4.   The ceramic assembled board (10) according to any one of claims 1 through 3,
**wherein,** the displacement e of the center line of the groove width c and the deepest part is not greater than c/4 at any arbitrarily taken cross section of the continuous dividing grooves (21).

5.   The ceramic assembled board (10) according to any one of claims 1 through 4,
**wherein,** the ceramic is silicon nitride and the continuous **dividing** grooves **are** formed by irradiating a laser beam from a fiber laser.

**Patentansprüche**

1.   Zusammengesetzte Keramikplatine (10) mit kontinuierlichen Teilungsnuten (21) auf einer Hauptfläche einer gesinterten Keramikplatine durch Laserbearbeitung zum Herstellen einer großen Anzahl von Schaltkreissubstraten, wobei mindestens eine der kontinuierlichen Teilungsnuten (21) einen größten Tiefenabschnitt und einen kleinsten Tiefenabschnitt mit einem Tiefenunterschied $\Delta d$ von 10 $\mu$m $\leq \Delta d \leq$ 50 $\mu$m hat,
und $\rho$/B $\leq$ 0,3 innerhalb des Bereichs von 0,1 $\leq$ dm/B $\leq$ 0,5,
**dadurch gekennzeichnet, dass**
die kontinuierlichen Teilungsnuten (21) auf nur einer der Hauptflächen ausgebildet sind und nicht auf einer anderen der Hauptflächen ausgebildet sind,
wobei hier der Krümmungsradius des unteren Abschnitts an jedem beliebig gewählten Querschnitt der kontinuierlichen Teilungsnuten (21) gleich p ist, die maximale Nuttiefe dm ist und die Platinendicke in einem Querschnitt am Teil der größten Tiefe der kontinuierlichen Teilungsnuten (21) gleich B ist.

2.   Zusammengesetzte Keramikplatine (10) nach Anspruch 1, wobei 0,053 $\leq \rho$/B $\leq$ 0,3.

3.   Zusammengesetzte Keramikplatine (10) nach Anspruch 1 oder 2, wobei
dm nicht größer als B/2 ist, die Nutbreite c nicht größer als 0,2 mm ist und die Breite c1 der Wärmeeinflusszonen, die an den gegenüberliegenden Seiten der Nuten ausgebildet sind, nicht größer als das 1,5-fache der Nutbreite c ist.

4.   Zusammengesetzte Keramikplatine (10) nach einem der Ansprüche 1 bis 3,
wobei die Verschiebung e der Mittelachse der Nutbreite c und des tiefsten Teils an einem beliebig gewählten Querschnitt der kontinuierlichen Teilungsnuten (21) nicht größer als c/4 ist.

5.   Zusammengesetzte Keramikplatine (10) nach einem der Ansprüche 1 bis 4,
wobei die Keramik Siliciumnitrid ist und die kontinuierlichen Teilungsnuten durch Bestrahlung mit einem Laserstrahl von einem Faserlaser gebildet werden.

**Revendications**

1.   Plaquette assemblée en céramique (10) ayant des rainures de séparation en continu (21) sur une surface principale d'une plaque de céramique frittée au moyen de l'usinage par laser afin de produire un grand nombre de substrats de circuit,

au moins l'une des rainures de séparation en continu (21) présente une section de profondeur la plus grande et une section de profondeur la plus petite avec une différence de profondeur $\Delta d$ de 10 $\mu$m $\leq \Delta d \leq$ 50 $\mu$m,

et p/B $\leq$ 0,3 dans la plage de 0,1 $\leq$ dm/B $\leq$ 0,5, **caractérisée en ce que**,

les rainures de séparation en continu (21) sont formées uniquement sur l'une des surfaces principales, et ne sont pas formées sur une autre des surfaces principales, ici, le rayon de courbure de la section inférieure est O au niveau d'une section transversale quelconque prise arbitrairement des rainures de séparation en continu (21), la profondeur de rainure maximale est dm, et l'épaisseur de plaquette est B dans une section transversale prise au niveau de la partie de profondeur la plus grande des rainures de séparation en continu (21).

2. Plaquette assemblée en céramique (10) selon la revendication 1, dans laquelle, 0,053 $\leq$ p / B 0,3.

3. Planche assemblée en céramique (10) selon la revendication 1 ou 2, dans laquelle,
dm n'est pas supérieure à B/2, la largeur de rainure c n'est pas supérieure à 0,2 mm et la largeur c1 des zones affectées thermiquement formées au niveau des côtés opposés des rainures n'est pas supérieure à 1,5 fois celle de la largeur de rainure c.

4. Planche assemblée en céramique (10) selon l'une quelconque des revendications 1 à 3,
dans laquelle, le déplacement e de la ligne centrale de la largeur de rainure c et de la partie la plus profonde n'est pas supérieur à c/4 au niveau d'une section transversale quelconque prise arbitrairement des rainures de séparation en continu (21).

5. Planche assemblée en céramique (10) selon l'une quelconque des revendications 1 à 4,
dans laquelle, la céramique est du nitrure de silicium et les rainures de séparation en continue sont formées en irradiant un faisceau laser provenant d'un laser à fibre.

Fig.1

Fig.2

Fig.3

Fig.4

Fig.5

Fig.6

Fig.7

Fig.8

Fig.9

## Characteristics of fiber laser

○ faster than conventional CO2 laser technique and does not entail any degradation of substrate strength

A fibre laser scribing method was developed.

１) high speed operation      :7200mm/min   ⟨▭⟩   2888mm/min

２) A CO2 laser technique can degrade the strength at the machined surface side and the Weibull coefficient

Fiber laser machining technique

## Fig.10

**REFERENCES CITED IN THE DESCRIPTION**

**Patent documents cited in the description**

- JP 2007081024 A
- JP 2008041945 A
- JP 2000044344 A
- JP 2003031731 A
- US 2009220721 A1